(19) **Europäisches Patentamt**

**European Patent Office**

**Office européen des brevets**

(11) **EP 1 298 791 A1**

(12) **EUROPEAN PATENT APPLICATION**

(43) Date of publication:
**02.04.2003 Bulletin 2003/14**

(51) Int Cl.⁷: **H03C 3/40**

(21) Application number: **01123075.2**

(22) Date of filing: **26.09.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Sony International (Europe) GmbH
10785 Berlin (DE)**

(72) Inventors:
• **Landing, Mikael, Adv.Tech.Ct.Stuttgart
70327 Stuttgart (DE)**
• **Brankovic, Veselin, Adv.Tech.Ct.Stuttgart
70327 Stuttgart (DE)**

• **Rebmann, Jochen, Adv.Tech.Ct.Stuttgart
70327 Stuttgart (DE)**
• **Eichel, Dirk, Adv.Tech.Ct.Stuttgart
70327 Stuttgart (DE)**
• **Amir-Alikhani, Hamid, Adv.Tech.Ct.Stuttgart
70327 Stuttgart (DE)**

(74) Representative: **Rupp, Christian, Dipl.-Phys. et al
Mitscherlich & Partner,
Patent- und Rechtsanwälte,
Postfach 33 06 09
80066 München (DE)**

(54) **Direct-conversion receiver using quadrature error correction**

(57)     The present invention generally relates to the field of direct-conversion receiver architectures for the processing of modulated RF signals, especially to an analog four-port hardware structure (404a and/or 404b) with a reduced power consumption applied to the I/Q demodulator (112b) and/or the I/Q modulator (112a) of a direct-conversion transceiver to compensate amplitude offsets and phase imbalances, a mobile receiver comprising said analog four-port hardware structure (404a and/or 404b).

FIG. 2

**Description**

FIELD AND BACKGROUND OF THE INVENTION

The present invention generally relates to the field of direct-conversion transceiver architectures for the processing of modulated RF signals, especially to an analog four-port hardware structure applied to the I/Q demodulator and/or the I/Q modulator of a direct-conversion transceiver to compensate amplitude offsets and phase imbalances, a mobile transceiver comprising said analog four-port hardware structure, and particularly to a method for calibrating and operating said mobile transceiver.

In order to understand the main idea of the underlying invention, it is necessary to give a brief mathematical description of equivalent low-pass signals and the generation of in-phase (I) and quadrature (Q) signals needed for the performance of I/Q modulation and/or I/Q demodulation.

Analog I/Q modulators and I/Q demodulators are functional entities which are frequently used in RF engineering. In an I/Q modulator, a real-valued RF signal x(t) having a frequency content concentrated in a frequency band in the vicinity of a center frequency $f_{RF}$ is represented by its complex-valued equivalent low-pass signal $x_{LP}(t)$, which is given as follows:

$$x_{LP}(t) = x_{+}(t) \cdot e^{-j \cdot 2\pi \cdot f_{RF} \cdot t}$$

In this equation, $x_{+}(t)$ denotes the so-called "analytical signal" or "pre-envelope" of the received RF signal x(t), which only consists of positive frequencies in x(t). It can be obtained from x(t) by means of the following equation:

$$x_{+}(t) = x(t) + j \cdot H\{x(t)\} = x(t) + j \cdot \frac{1}{\pi} \cdot \int_{-\infty}^{+\infty} \frac{x(\tau)}{t - \tau} \, d\tau$$

with

$$H\{x(t)\} := h(t) * x(t) = \int_{-\infty}^{+\infty} x(\tau) \cdot h(t - \tau) \, d\tau,$$

thereby using

$$h(t) := \frac{1}{\pi \cdot t} \quad \forall \, t \in \mathbf{R}$$

and

$$H(f) = \int_{-\infty}^{+\infty} h(t) \cdot e^{-j \cdot 2\pi \cdot f \cdot t} \, dt = -j \cdot \text{sgn}(f) = \begin{cases} -j & \text{for} \ f > 0 \\ 0 & \text{for} \ f = 0 \\ +j & \text{for} \ f < 0 \end{cases}, \quad j := \sqrt{-1},$$

wherein

h(t)    denotes the impulse response of a Hilbert transformer which servers as a 90° phase shifter,
H(f)    is the Fourier transform of h(t), and
H{·}    represents the Hilbert transform operator.

Using the Fourier transform of the analytical signal $x_+(t)$, which is given by

$$X_+(f) = X(f) \cdot [1 + j \cdot H(f)] = X(f) \cdot [1 + \text{sgn}(f)],$$

the Fourier transform of the equivalent low-pass signal $x_{LP}(t)$ yields

$$x_{LP}(f) = X_+(f + f_{RF}).$$

In general, the complex-valued equivalent low-pass signal $x_{LP}(t)$ can be expressed as

$$x_{LP}(t) = i(t) + j \cdot q(t),$$

wherein

$$i(t) := \text{Re}\{x_{LP}(t)\}$$

denotes the in-phase (I) signal, and

$$q(t) := \text{Im}\{x_{LP}(t)\}$$

denotes the quadrature (Q) signal.

Using i(t) and q(t), in case of up-conversion the I/Q modulated RF signal x(t) to be transmitted can be written as

$$x(t) = \text{Re}\{x_+(t)\} = \text{Re}\{x_{LP}(t) \cdot e^{+j \cdot 2\pi \cdot f_{RF} \cdot t}\}$$

$$= i(t) \cdot \cos(2\pi \cdot f_{RF} \cdot t) - q(t) \cdot \sin(2\pi \cdot f_{RF} \cdot t).$$

In case of down-conversion, the I/Q demodulated baseband signals i(t) and q(t) can be obtained by multiplying the received RF signal x(t) with sinusoidal functions and low-pass filtering the result:

$$i(t) = x(t) \cdot 2 \cdot \cos\left(2\pi \cdot f_{RF} \cdot t\right) \cdot \text{rect}\left(\frac{f}{2 \cdot f_{co}}\right),$$

$$q(t) = -x(t) \cdot 2 \cdot \sin\left(2\pi \cdot f_{RF} \cdot t\right) \cdot \text{rect}\left(\frac{f}{2 \cdot f_{co}}\right),$$

thereby using

$$\text{rect}\left(\frac{f}{2 \cdot f_{co}}\right) := \begin{cases} 1 & \text{for } |f| < f_{co} \\ 1/2 & \text{for } |f| = f_{co} \\ 0 & \text{otherwise} \end{cases}$$

and the three trigonometric identities

$$\cos x \cdot \cos y = \frac{1}{2} \cdot \left[\cos(x+y) + \cos(x-y)\right] \quad \forall \ x, y \in \wp, \qquad (I)$$

$$\sin x \cdot \sin y = \frac{1}{2} \cdot \left[\cos(x-y) - \cos(x+y)\right] \quad \forall \ x, y \in \wp, \text{ and } \quad (II)$$

$$\cos x \cdot \sin y = \frac{1}{2} \cdot \left[\sin(x+y) - \sin(x-y)\right] \quad \forall \ x, y \in \wp, \qquad (III)$$

wherein

$f_{co}$     denotes the cut-off frequency of the applied low-pass filters, and
$rect(\cdot)$     denotes the rectangular function.

Since the analog RF signal x(t) can be written as

$$x(t) = x_{BB}(t) \cdot \cos(2\pi \cdot f_{RF} \cdot t),$$

wherein $x_{BB}(t)$ denotes the analog baseband signal,
said analog baseband signal $x_{BB}(t)$ can be derived from the equivalent low-pass signal $x_{LP}(t)$ as follows:

$$x_{BB}(t) = |x_{LP}(t)| = \sqrt{Re^2\{x_{LP}(t)\} + Im^2\{x_{LP}(t)\}} = \sqrt{i^2(t) + q^2(t)}.$$

In specific cases the process of up- and down-conversion turns out to be a serious issue for the applied RF system solution, mainly due to simplicity requirements and low-cost approaches. Nowadays, typical approaches applied to I/Q modulators and demodulators usually eliminate the impact of direct current (DC) offsets and neglect the impacts of an I/Q imbalance.

BRIEF DESCRIPTION OF THE STATE OF THE ART

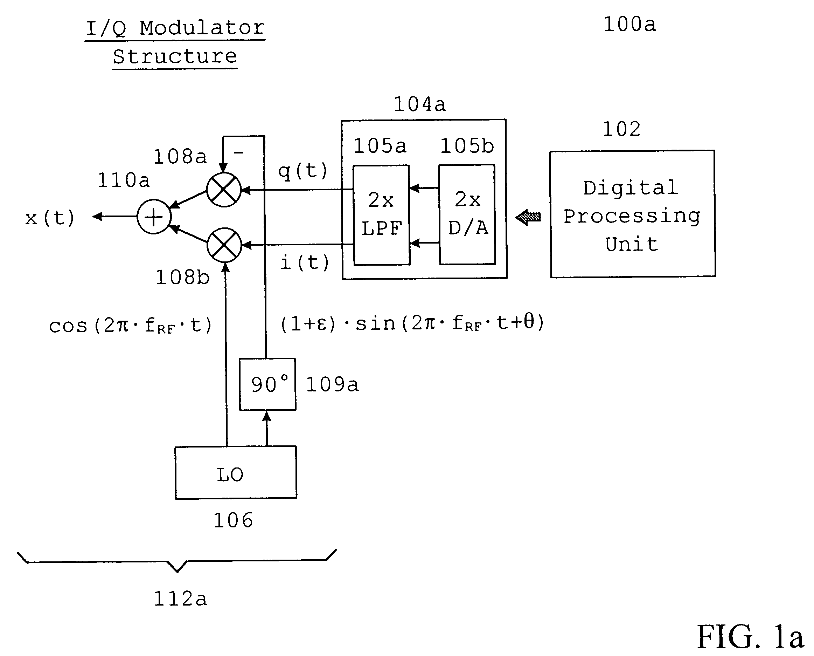

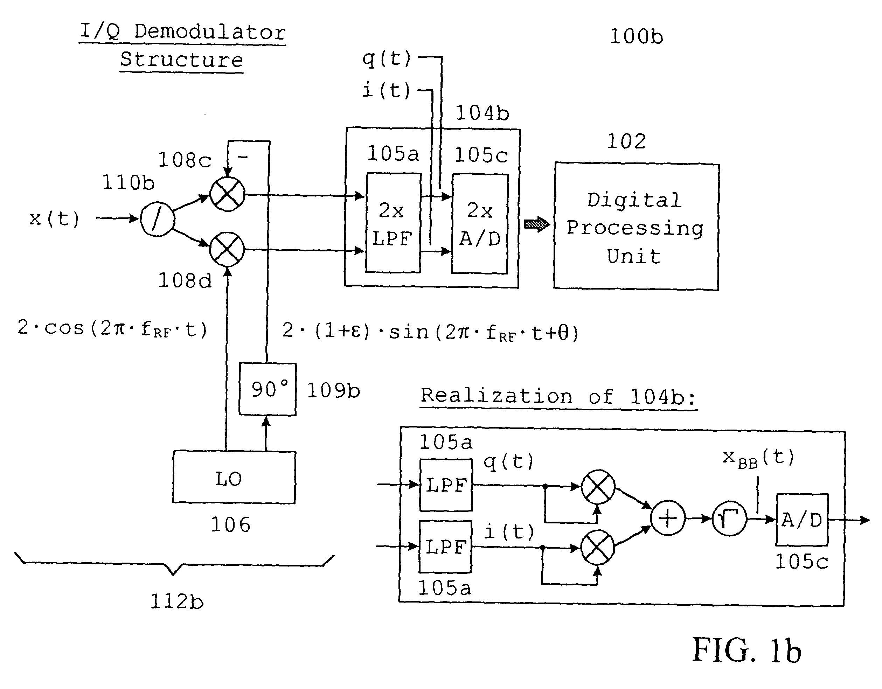

Conventional approaches for I/Q modulators and I/Q demodulators in mobile transceivers according to the state of the art are mainly directed to mobile telecommunication systems for digitally compensating imbalances with the aid of a digital processing unit as depicted in Figs. 1a+b. Therefore, the digital baseband parts of current digital systems provide capabilities for performing a phase and amplitude compensation of a received signal.
According to the state of the art, there are different methods to the problem of compensating amplitude and phase errors arising in the scope of RF down-conversion, each of them having certain advantages and disadvantages. In order to explain these solutions and to understand the idea of the underlying invention, it is necessary to briefly investigate the characterizing features of two frequently employed receiver architectures, heterodyne receivers and homodyne receivers, especially with regard to the effects of amplitude offsets and phase imbalances on the quality of the demodulated signal.
Heterodyne receivers (also called "low-IF" receivers) downconvert an RF signal to an intermediate frequency (IF), perform band-pass filtering and amplification, and translate the spectrum to a lower frequency. In case of phase or frequency modulation, down-conversion to the baseband requires signals with both in-phase (I) and quadrature (Q) components since both sidebands of an RF signal carries different information and must therefore be separated into quadrature phases. Perhaps the most important feature of heterodyne receivers is their selectivity, which means their capability to process and select small signals in the presence of strong interferers. A low-IF receiver architecture can be implemented in a highly integrated way and is not sensitive to parasitric effects such as DC-offset voltages and self-mixing products. Nevertheless, heterodyne receivers entail a number of disadvantages. For example, this architecture severely suffers from the problem of image signals coming from adjacent channels which can not entirely be removed by RF band-pass filtering. The trade-off between image rejection and channel selection typically requires a relatively high intermediate frequency (IF), which makes it difficult to integrate the IF filter monolithically. Furthermore, the reject filter is a passive, bulky device which must be placed off-chip and driven as a 50-Ω load.

In the literature, many methods have been proposed to improve the matching issues in the low-IF receiver architecture. For example, modifications of the phase-shift circuit were introduced along with a careful tuning and trimming of the analog circuits. In another approach, a double quadrature down-converter serves to make analog circuits more robust with respect to phase mismatches. Moreover, digital approaches were presented for the correction of the I/Q mismatch.

Homodyne receivers (also called "direct down-conversion" or "zero-IF" receivers) translate the channel of interest directly to the baseband. Consequently, the problem of distorting image frequencies is circumvented. Generally, a direct-conversion receiver architecture requires fewer discrete components and achieves a higher integration level than other traditional receiver architectures. For frequency- and phase-modulated signals the down-conversion must provide in-phase (I) and quadrature (Q) signals in order to avoid a loss of information. Thereby, quadrature mixing in theory provides infinite attenuation for the entire image band. In practice, however, quadrature down-conversion to a very low intermediate frequency (IF) involves one serious problem. Since unavoidable imbalances in the analog front-end between the I-and Q-branches, lead to a finite and usually insufficient rejection of the image frequency band, interferences distorting the quality of the received signal arise. These imbalances mainly occur due to finite tolerances of capacitor and resistor values which are used to implement the analog components.

Besides, said architectures entail several other disadvantages. For instance, DC-offset voltages due to self-mixing and flicker noise substantially corrupt the obtained baseband signal. Moreover, mismatches between the in-phase (I) and quadrature (Q) phase channels also distort the baseband signal constellation, thereby degrading the signal-to-noise (SNR) performance. These I/Q mismatches can be reduced by means of a careful circuit design and fabrication procedure. Nevertheless, both DC-offset voltages and flicker noise are still difficult to deal with and require further efforts to overcome.

Whereas a perfectly balanced quadrature down-conversion corresponds to a pure frequency translation, said imbalances also introduce a further frequency translation in the other direction. Consequently, this results in a mixture of the image signal and the desired signal. In conventional direct down-conversion receivers, phase imbalances of up to 2° and amplitude imbalances of up to 2 % are realistic, which results in up to 40 dB attenuation of the image signal.

In the literature, both analog and digital techniques are presented which can be used for compensating the effects of I/Q imbalance. Thereby, interference cancellation based phase imbalance and amplitude offset compensation structures are described utilizing baseband digital signal processing.

In order to gain more insight into the effect of I/Q imbalance, the received signal shall be given in the form

$$x_{RF}(t) = a \cdot \cos(\omega_c \cdot t) - b \cdot \sin(\omega_c \cdot t)$$

with

$$\omega_c = 2\pi \cdot f_c \text{ and } a,b \in \{-1;+1\}$$

wherein $f_c$ denotes the center frequency of the received RF signal. In the following it shall be assumed that the in-phase (I) and the quadrature (Q) component of the local oscillator (LO) signal are given by

$$x_{LO,I}(t) := 2 \cdot \left(1 + \frac{\varepsilon}{2}\right) \cdot \cos\left(\omega_c \cdot t + \frac{\theta}{2}\right),$$

$$x_{LO,Q}(t) := 2 \cdot \left(1 - \frac{\varepsilon}{2}\right) \cdot \cos\left(\omega_c \cdot t - \frac{\theta}{2}\right),$$

wherein

$f_{LO}$     is the frequency of the local oscillator (LO),
$\varepsilon$     represents the amplitude error, and
$\theta$     represents the phase error.

The factor 2 in the equations for $x_{LO,I}(t)$ and $x_{LO,Q}(t)$ is included to simplify the results. Multiplying $x_{in}(t)$ with $x_{LO,I}(t)$ and $x_{LO,Q}(t)$, respectively, and low-pass filtering the results yields the following baseband (BB) signals:

$$x_{BB,I}(t) = a \cdot \left(1 + \frac{\varepsilon}{2}\right) \cdot \cos\left(\frac{\theta}{2}\right) - b \cdot \left(1 + \frac{\varepsilon}{2}\right) \cdot \sin\left(\frac{\theta}{2}\right),$$

$$x_{BB,Q}(t) = -a \cdot \left(1 - \frac{\varepsilon}{2}\right) \cdot \sin\left(\frac{\theta}{2}\right) + b \cdot \left(1 - \frac{\varepsilon}{2}\right) \cdot \cos\left(\frac{\theta}{2}\right),$$

thereby using the three trigonometric identities (I), (II) and (III).

Gain errors and phase imbalances can be seen best by inspecting down-converted QPSK signals in the time domain. Thereby, a gain error simply appears as a non-unity scale factor in the amplitude. Phase imbalances, on the other hand, corrupt each channel by a fraction of the data pulses in the other channel, in essence degrading the signal-to-noise ratio (SNR) if the in-phase (I) and quadrature (Q) streams are uncorrelated. In practice, it is desirable to maintain the amplitude mismatch $\varepsilon$ below 1 and the phase error $\theta$ below 5°, depending on the respective type of modulation.

Besides direct-conversion receivers, amplitude offsets and phase imbalances are also a critical issue in the scope of image-reject receivers. In the following section a brief description of the signal down-conversion using a direct-conversion receiver architecture shall be given, in which the effect of gain and phase errors can easily be studied.

The idea in an image-reject architecture is to differently process the desired RF signal $x_{sig}(t)$, which shall be written as $x_{RF}(t)$ in the following sections, and the image signal $x_{im}(t)$, thereby allowing a cancellation of the image signal by means of its negated replica. Said distinction between the RF signal $x_{RF}(t)$ and the image $x_{im}(t)$ is possible since these signals lie on different sides of the LO frequency $f_{LO}$:

$f_{im} < f_{LO} < f_{RF}$ or $f_{RF} < f_{LO} < f_{im}$,

wherein

$f_{im}$    is the center frequency of the image signal,
$f_{LO}$    is the frequency of the local oscillator (LO), and
$f_{RF}$    is the center frequency of the desired RF signal.

An image-reject architecture originating from a single-sideband (SSB) modulator was introduced by Hartley in 1928. Hartley's circuit mixes an RF input signal with the two quadrature signals $x_{LO,A}(t)$ and $X_{LO,B}(t)$ of a given local oscillator (LO),

$$x_{LO,A}(t) := A_{LO} \cdot \sin(\omega_{LO} \cdot t)$$

and

$$x_{LO,B}(t) := A_{LO} \cdot \cos(\omega_{LO} \cdot t)$$

with

$$\omega_{LO} = 2\pi \cdot f_{LO},$$

wherein

$A_{LO}$    denotes the amplitude of the LO signal,
$f_{LO}$    is the frequency of the LO signal, and
t    represents the observation instant.

low-pass filters the resulting signals, and shifts one by 90° before adding them together. To understand the underlying

principle, an input $x_{in}(t)$ signal shall be given which consists of a desired signal $x_{sig}(t)$ and an image signal $x_{im}(t)$ :

$$x_{in}(t) = x_{sig}(t) + x_{im}(t)$$

with

$$x_{sig}(t) \equiv x_{RF}(t) = A_{RF} \cdot \cos(\omega_{RF} \cdot t), x_{im}(t) = A_{im} \cdot \sin(\omega_{im} \cdot t),$$

$$\omega_{RF} = 2\pi \cdot f_{RF} \text{ and } \omega_{im} = 2\pi \cdot f_{im}$$

wherein

$A_{im}$     denotes the amplitude of the image signal,
$A_{RF}$     denotes the amplitude of the desired signal,
$f_{im}$     is the center frequency of the image signal,
$f_{RF}$     is the center frequency of the desired signal, and
$t$     represents the observation instant.

Thereby, without a loss of generality, low-side injection shall be assumed:

$$f_{IF} := f_{RF} - f_{LO} = f_{LO} - f_{im} \text{ (with } f_{RF} > f_{LO} > f_{im})$$

wherein $f_{IF}$ denotes an intermediate frequency (IF).
Multiplying $x_{in}(t)$ with $x_{LO,A}(t)$ and $x_{LO,B}(t)$, neglecting high-frequency components and shifting the signal $x_{in}(t) \cdot x_{LO,A}(t)$ by 90° yields:

$$a(t) = x_{in}(t) \cdot x_{LO,A}(t)$$

$$= \frac{A_{RF} \cdot A_{LO}}{2} \cdot \cos\left[\left(\omega_{RF} - \omega_{LO}\right) \cdot t\right] - \frac{A_{im} \cdot A_{LO}}{2} \cdot \cos\left[\left(\omega_{LO} - \omega_{im}\right) \cdot t\right]$$

and

$$b(t) = x_{in}(t) \cdot x_{LO,B}(t)$$

$$= \frac{A_{RF} \cdot A_{LO}}{2} \cdot \cos\left[\left(\omega_{RF} - \omega_{LO}\right) \cdot t\right] + \frac{A_{im} \cdot A_{LO}}{2} \cdot \cos\left[\left(\omega_{LO} - \omega_{im}\right) \cdot t\right]$$

using (I), (III) and $\sin(x-90°) = -\cos(x) \ \forall \ x \in \mathbb{R}$ .
By adding $a(t)$ and $b(t)$, the following output signal can be obtained:

$$x_{IF}(t) = a(t) + b(t) = A_{RF} \cdot A_{LO} \cdot \cos(\omega_{IF} \cdot t)$$

with

$$\omega_{IF} = 2\pi \cdot f_{IF}.$$

Thus, the desired signal $x_{sig}(t)$ is down-converted to an intermediate frequency (IF) without any distortion caused by the image signal $x_{im}(t)$ since the signal components $x_A(t)$ and $x_B(t)$ have the same polarity, whereas the components of the image signal $x_{im}(t)$ have opposite polarities.

However, the principal drawback of Hartley's architecture is its sensitivity to amplitude mismatches and/or phase imbalances. If the LO signals $x_{LO,A}(t)$ and $x_{LO,B}(t)$ are not in exact quadrature (which means that the phase difference of $x_{LO,A}(t)$ and $x_{LO,B}(t)$ is not exactly equal to $\pm 90°$), or if the gains and phase shifts in the paths yielding $x_A(t)$ and $x_B(t)$ are not identical, the cancellation of the image signal as described above is incomplete. Hence, the image signal distorts the down-converted signal $x_{IF}(t)$.

In order to better understand the effect of amplitude mismatches and phase imbalances on the quality of the down-converted signal $x_{IF}(t)$, a further calculation shall be performed. In the following it shall be assumed that the LO signals are given by

$$x_{LO,A}(t) := A_{LO} \cdot \sin(\omega_{LO} \cdot t)$$

and

$$x_{LO,B}(t) := (A_{LO} + \varepsilon) \cdot \cos(\omega_{LO} \cdot t + \theta),$$

wherein

$f_{LO}$    is the frequency of the local oscillator (LO),
$\varepsilon$     represents the amplitude offset,
$\theta$     represents the phase imbalance, and
$t$     denotes the observation instant.

In this case, multiplying $x_{in}(t)$ with $x_{LO,A}(t)$ and $x_{LO,B}(t)$, neglecting high-frequency components and shifting the signal $x_{in}(t) \cdot x_{LO,A}(t)$ by $90°$ yields:

$$a(t) = A_{LO} \cdot \left\{ \frac{A_{RF}}{2} \cdot \cos\left[(\omega_{RF} - \omega_{LO}) \cdot t\right] - \frac{A_{im}}{2} \cdot \cos\left[(\omega_{LO} - \omega_{im}) \cdot t\right] \right\}$$

and

$$b(t) = (A_{LO} + \varepsilon) \cdot \left\{ \frac{A_{RF}}{2} \cdot \cos\left[(\omega_{RF} - \omega_{LO}) \cdot t + \theta\right] + \frac{A_{im}}{2} \cdot \cos\left[(\omega_{LO} - \omega_{im}) \cdot t + \theta\right] \right\}$$

using (I), (III) and $\sin(x - 90°) = -\cos(x) \; \forall \; x \in \mathbb{R}$.

Adding $a(t)$ and $b(t)$ yields both the desired signal $x_{sig}(t)$ and a fraction of the down-converted image signal $x_{im}(t)$:

$$x_{IF}(t) = a(t) + b(t) \equiv x_{sig}(t) + x_{im}(t)$$

with

$$x_{sig}(t) := \frac{A_{RF} \cdot (A_{LO} + \varepsilon)}{2} \cdot \cos(\omega_{IF} \cdot t + \theta) + \frac{A_{LO} \cdot A_{RF}}{2} \cdot \cos(\omega_{IF} \cdot t)$$

and

$$x_{im}(t) := \frac{A_{im} \cdot (A_{LO} + \varepsilon)}{2} \cdot \cos(\omega_{IF} \cdot t + \theta) - \frac{A_{LO} \cdot A_{im}}{2} \cdot \cos(\omega_{IF} \cdot t),$$

using

$$\omega_{IF} = 2\pi \cdot f_{IF} \text{ and } f_{IF} := |f_{RF} - f_{LO}| = |f_{LO} - f_{im}|.$$

In the PCT application WO 00/52840 a multi-band transceiver architecture utilizing a direct-conversion receiver is disclosed for directly down-converting RF signals to the base-band. Thereby, the direct down-conversion receiver comprises a tunable oscillator system for providing a first signal $s_1(t)$ at a frequency $f_1$ being the n-th order subharmonic of the selected carrier frequency $f_2 = n \cdot f_1$ (with $n \in \mathbb{N} \setminus \{1\}$) of a second signal $s_2(t)$ within the selected frequency band, filtering means and a frequency translator configured to switch said second signal $s_2(t)$ to the output by means of a switching action occurring at $n \cdot f_1$.

## DEFICIENCIES AND DISADVANTAGES OF THE KNOWN SOLUTIONS OF THE STATE OF THE ART

Common dual mode transceiver architectures are using separated receive (RX) and transmit (TX) chains for different operation frequency bands. Consequently, the number of components necessary and the power consumption is very high as each chain has its own filters, mixers and amplifiers which are not reused. For example, multi-band transceivers have the problem of an increased power consumption due to two or more independent receive (RX) and transmit (TX) chains.

Many conventional transceivers show furthermore the restriction that they can only be operated in combination with standards that provide a limited bandwidth.

In addition, conventional transceivers in accordance with the present state of the art do not imply sufficient possibilities for an image rejection and the suppression of interferences due to adjacent channels.

## OBJECT OF THE UNDERLYING INVENTION

In view of the explanations mentioned above it is the object of the invention to propose a novel low-cost and low-power approach for an analog circuitry applied to the I/Q demodulator and/or the I/Q modulator of a direct-conversion transceiver architecture, which enables an improved compensation of amplitude offsets and phase imbalances.

This object is achieved by means of the features in the independent patent claims. Advantageous further developments are defined in the dependent patent claims.

## SUMMARY OF THE INVENTION

In contrast to the above-mentioned approach to perform a digital compensation of the I/Q imbalance according to the solution described in WO 00/52840, the proposed solution according to the preferred embodiment of the underlying invention refers to an analog compensation of amplitude offsets and phase imbalances occurring in the I/Q modulator and I/Q demodulator of a direct-conversion transceiver by introducing additional analog hardware means. Thereby, said analog circuit is specially designed to cope with I/Q imbalances and DC offsets even in case of wideband operation. Besides, a specific solution for a direct-conversion transceiver applied to an half duplex time division radio system, and a method for calibrating and operating said direct-conversion transceiver are proposed which can easily be realized. A practical application of said system refers to mobile radio systems using the HiperLAN/2 (H2) standard.

The advantage of using said analog circuit consists in needing less digital operations, which involves a reduced complexity of the digital part and a reduced power consumption of the entire system. An analog compensation of the I/Q imbalances and a compensation of the DC offsets can be achieved by means of a low-cost solution using a simple analog circuitry with a reduced power consumption.

Whereas the transceiver structure proposed in the PCT application WO 00/52840 comprises separate up- and down-conversion blocks and a separate mixer circuitry, in the proposed solution according to the preferred embodiment of the underlying invention, by contrast, mixer entities used for an I/Q modulation and an I/Q demodulation can be reused by applying said analog circuitry for compensating I/Q imperfections. Thereby, the same analog compensation structure can advantageously be applied to the transmit (TX) and receive (RX) mode. Moreover, the calibration procedure can considerably be simplified.

The purpose of the calibration procedure needed for an I/Q modulation and/or I/Q demodulation is to evaluate the gain block settings of the proposed entity which are needed for an analog I/Q compensation and DC offset compensation. Thereby, a calibration procedure has to be performed for each frequency channel of operation. Said calibration procedure may also be performed for a limited number of operation frequency channels, and for the rest of them the calibration values needed for the compensation hardware may be set by means of an interpolation of the given calibration values.

BRIEF DESCRIPTION OF THE CLAIMS

Claims 1, 2, 7, 8, 13 and 14 and the dependent claims 3 to 6, 9 to 12 and 15 to 18 refer to an analog four-port hardware structure used for the processing of modulated RF signals in a direct down-conversion receiver, a mobile transmitter and a direct-conversion transceiver, respectively. Thereby, said analog four-port hardware structure is placed between the up- and/or down-conversion mixers and the digital-to-analog and/or analog-to-digital converter in the modulator and/or demodulator structure of said direct down-conversion receiver, mobile transmitter or direct-conversion transceiver in order to compensate imbalances caused by amplitude and/or phase offsets.

In addition, claims 19 to 24 relate to a method for calibrating the in-phase (I) and the quadrature (Q) signal in the I/Q demodulator of a direct down-conversion receiver, the I/Q modulator of a mobile transmitter and the joined I/Q modulator and I/Q demodulator of a direct-conversion transceiver using an analog four-port hardware structure according to anyone of the preceding claims.

BRIEF DESCRIPTION OF THE DRAWINGS

Further advantages of the underlying invention result from the subordinate claims as well as from the following description of two preferred embodiments of the invention which are depicted in the following drawings. Herein,

Fig. 1a      shows the structure of the I/Q modulator 112a in a solution according to the state of the art,

Fig. 1b      shows the structure of the I/Q demodulator 112b in a solution according to the state of the art,

Fig. 2       presents the structure of the I/Q demodulator 112b comprising additional analog hardware functionality 202a+b according to an,

Fig. 3       presents the structure of the I/Q modulator 112a comprising additional analog hardware functionality 302a+b according to an preferred,

Fig. 4       illustrates the functionality of the proposed joined I/Q modulator and I/Q demodulator 410 according to an embodiment, which is suitable for half duplex time division radio systems,

Fig. 5a      shows the proposed analog circuitry 404a according to embodiment used for compensating the I/Q imbalance for the case of an I/Q modulator 112a, wherein a general solution 500a is employed,

Fig. 5b      shows the proposed analog circuitry 404a according to an embodiment used for compensating the I/Q imbalance for the case of an I/Q modulator 112a, wherein a special solution 500b with reduced complexity is employed for cases where the phase imbalance can be considered as small,

Fig. 6a      shows the proposed analog circuitry according to an embodiment used for compensating the I/Q imbalance for the case of an I/Q demodulator 112b, wherein a general solution 600a is employed,

Fig. 6b      shows the proposed analog circuitry according to an embodiment used for compensating the I/Q imbalance for the case of an I/Q demodulator 112b, wherein a special solution 600b with a reduced complexity is employed for cases where the phase imbalance can be considered as small,

Fig. 7       shows a general solution 700 for the proposed analog four-port hardware structure 404a according to an embodiment used for compensating the I/Q imbalance in case of a joined I/Q demodulator and I/Q modulator 410 applied to half duplex time division radio systems,

Fig. 8       shows a special solution 800 for the proposed analog four-port hardware structure 404a with reduced complexity according to an used for compensating the I/Q imbalance in case of a joined I/Q demodulator and I/Q modulator 410 applied to half duplex time division radio systems for cases when the phase imbalance can be considered as small,

Fig. 9     shows the proposed analog four-port hardware structure 404b according to an embodiment used for compensating DC offset voltages,

Fig. 10    exhibits a vector diagram 1000 which illustrates the problem of the I/Q imbalance before being compensated,

Fig. 11    presents mechanisms 1100a+b according to an embodiment for compensating the I/Q imbalance realized by means of the analog four-port hardware structure 404a as depicted in Figs. 4 to 8,

Fig. 12    presents a complete direct down-conversion receiver 1200 realizing the analog approach according to the preferred embodiment of the underlying invention,

Fig. 13    exhibits the simulation set-up 1300 for the compensation of the in-phase (I) and quadrature (Q) channel according to an embodiment,

Fig. 14a   shows a FFT spectrum 1400a in case of a single-sideband (SSB) rejection, in which a compensation of the I/Q imbalance is not performed, and finally

Fig. 14b   shows a FFT spectrum 1400b in case of a single-sideband (SSB) rejection, in which a compensation of the I/Q imbalance is performed according to an embodiment.

DETAILED DESCRIPTION OF THE UNDERLYING INVENTION

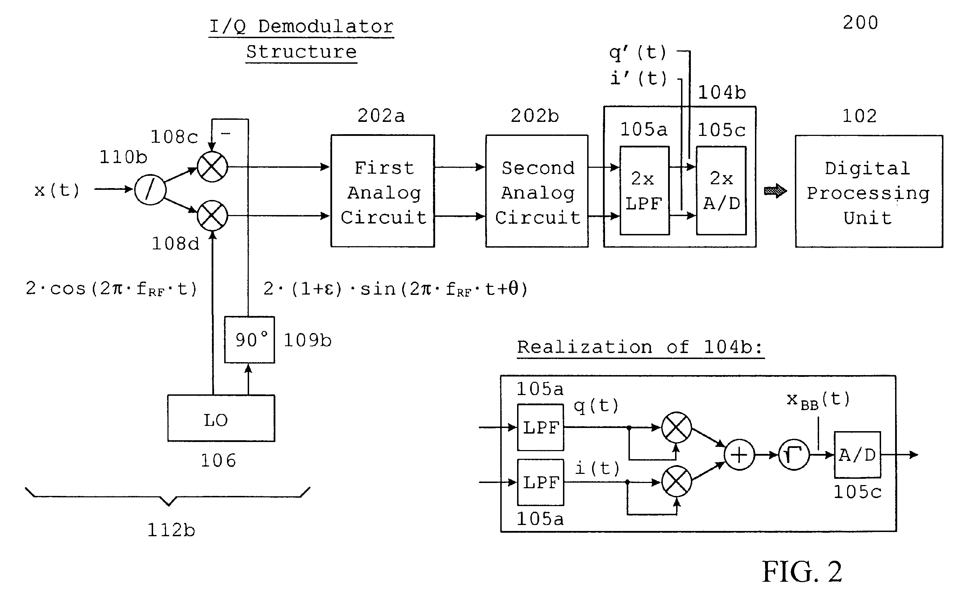

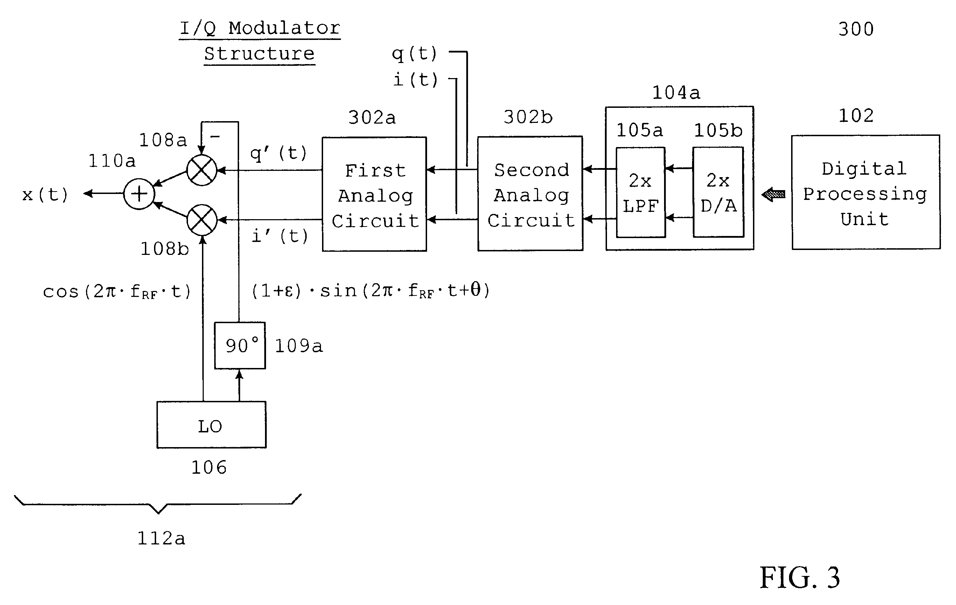

In the following the functions of the elements comprised in a first embodiment of the underlying invention as depicted in Figs. 2 to 14b are explained in comparison with an already known solution according to the state of the art as depicted in Figs. 1a+b, which is already described above.

In the solution according to the preferred embodiment of the underlying invention as depicted in Figs. 2 to 4 two four-port blocks 202a+b, 302a+b or 404a+b comprising analog means for compensating I/Q imbalance and DC offsets are proposed. These two functional blocks 202a+b, 302a+b or 404a+b, which will be explained in detail in the following sections, are placed between the mixer entities 108a+b, 108c+d or 406a+b and the low-pass filter entities 105a. Within the chain both blocks 108a+b, 108c+d or 406a+b and 105a may exchange the position within the architecture 200, 300 or 400 for the I/Q modulator 112a, the I/Q demodulator 112b or the joined I/Q modulator and I/Q demodulator 410 suitable for half duplex time division radio systems.

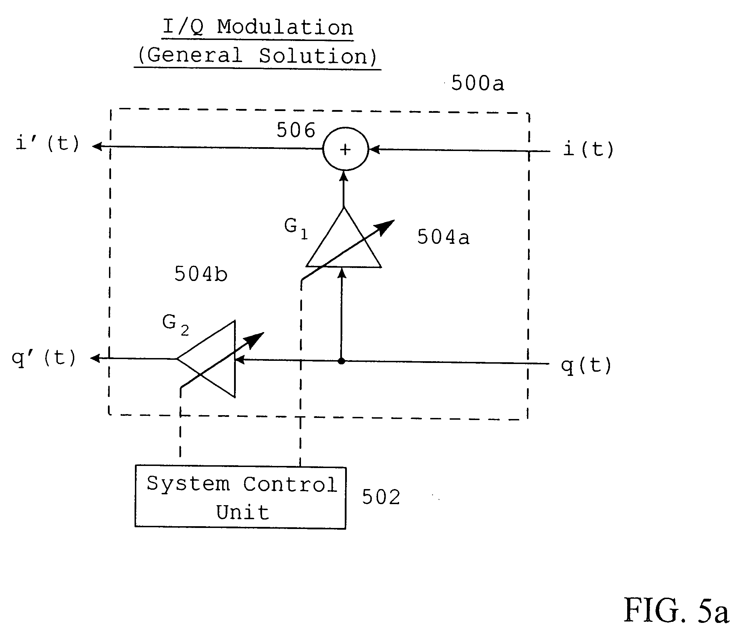

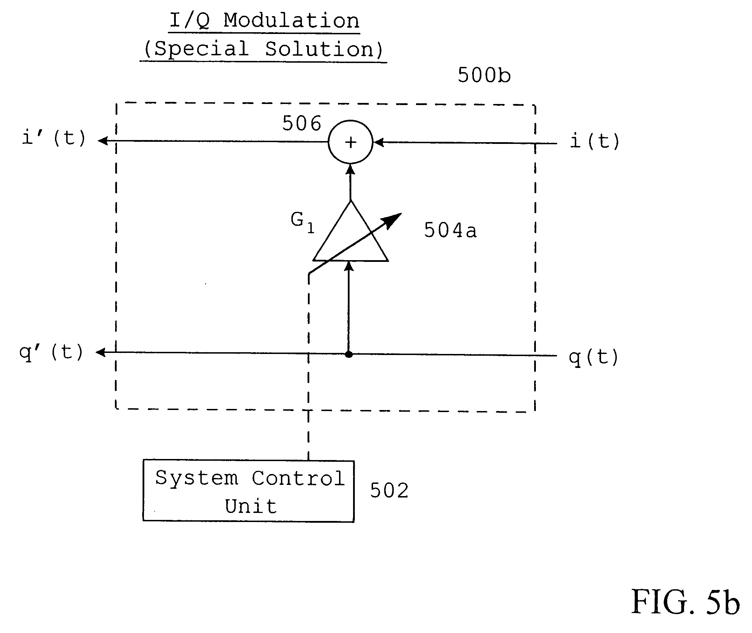

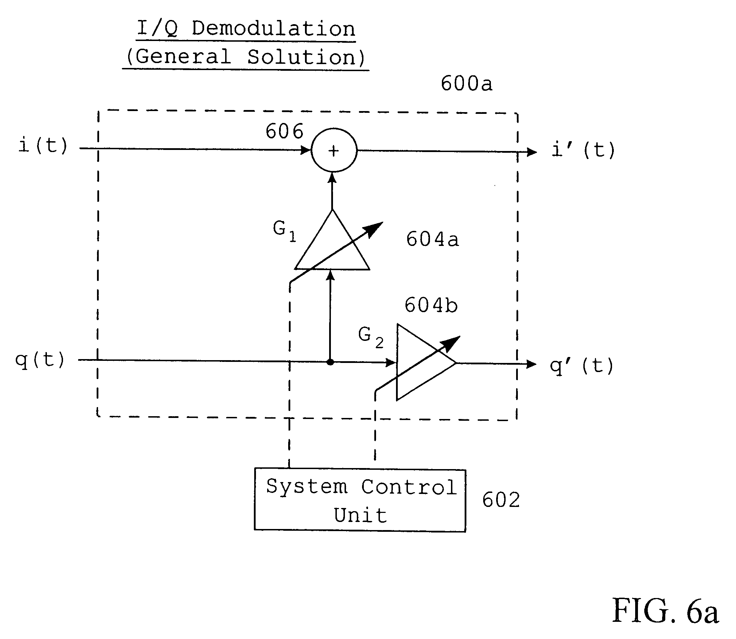

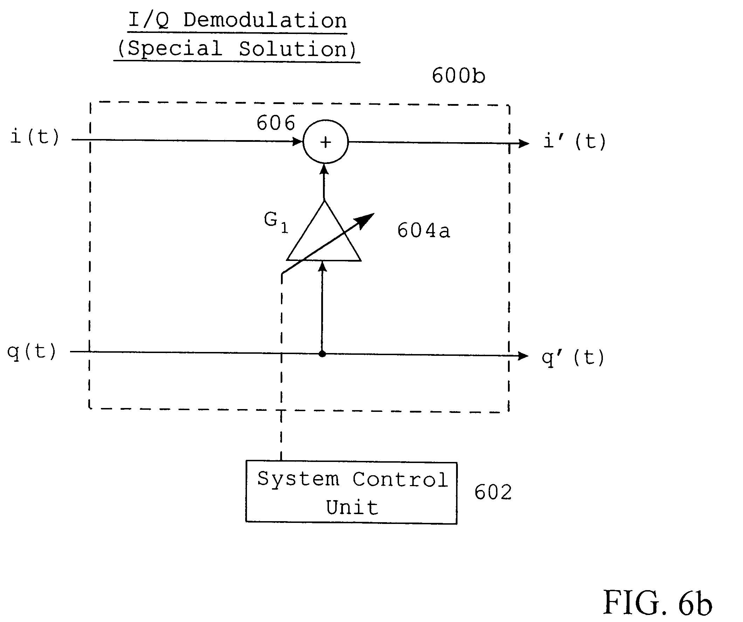

In Figs. 2 to 4, analog four-port hardware structures 202a+b, 302a+b and 404a+b for performing an I/Q compensation are shown. The details of said analog circuits can be taken from Figs. 5a+b and 6a+b. Thereby, each of the proposed analog four-port hardware structures 202a+b, 302a+b or 404a+b comprises two input ports and two output ports, in which a first input signal is connected to a first input port intended for the non-compensated in-phase signal i(t), and the second input signal is connected to a second input port intended for the non-compensated quadrature signal q(t). It has to be noted that the opposite signal allocation can also be applied.

In general, each input signal is provided with two chains. According to the general first solution 500a and 600a of the underlying invention as depicted in Figs. 5a and 6a, the non-compensated quadrature signal q(t) is multiplied with a factor $G_1$, and added to the non-compensated in-phase signal i(t), thereby yielding the compensated in-phase signal i'(t), which is led to the output port of a first chain. The compensated quadrature signal q'(t) can be obtained at the output port of a second chain by multiplying the quadrature signal q(t) with the factor $G_2$:

$$\begin{bmatrix} i'(t) \\ q'(t) \end{bmatrix} = \begin{pmatrix} 1 & G_1 \\ 0 & G_2 \end{pmatrix} \cdot \begin{bmatrix} i(t) \\ q(t) \end{bmatrix} \quad (1)$$

$$\text{with } G_1, G_2 \in \text{\reth}.$$

According to a special second solution 500b and 600b of the underlying invention as depicted in Figs. 5b and 6b, the non-compensated quadrature signal q(t) is also multiplied with a factor $G_1$, and added to the non-compensated in-phase signal i(t), thereby yielding the compensated in-phase signal i'(t), which is led to the output port of a first chain. However, the compensated quadrature signal q'(t) at the output port of a second chain is identical with the non-compensated quadrature signal q(t):

$$\begin{bmatrix} i'(t) \\ q'(t) \end{bmatrix} = \begin{pmatrix} 1 & G_1 \\ 0 & 1 \end{pmatrix} \cdot \begin{bmatrix} i(t) \\ q(t) \end{bmatrix} \quad (2)$$

$$\text{with } G_1 \in \wp.$$

In this context, it should be noted that

- each of the gains ($G_1$ and/or $G_2$) may take negative values ($|G_1| < 1$ and/or $|G_2| < 1$), thereby serving as an attenuation, or positive values ($|G_1| > 1$ and/or $|G_2| > 1$), thereby acting as an amplification,
- the variable gain amplifiers (VGAs) forming the gain blocks 504a+b and 604a+b can be realized by a plurality of different hardware solutions,
- the gains $G_1$ and $G_2$ of said gain blocks 504a+b and 604a+b are optionally adjusted by a systems control unit 502, and
- the whole analog four-port hardware structure 404a can be integrated in the same analog chip, where the mixer components 108a+b, 108c+d or 406a+b are placed.

Compared with the general first solution 500a, 600a and 700 as depicted in Figs. 5a, 6a and 7, in case of the special second solution 500b, 600b and 800 as depicted in Figs. 5b, 6b and 8 the hardware complexity of the described analog four-port hardware structure 404a can optionally be reduced by omitting the second gain block 504b, 604b and 704b, respectively, since only one gain block 504a, 604a or 804 providing an amplification or attenuation by multiplying the non-compensated quadrature signal q(t) with the factor $G_1$ is actually needed. This especially applies to structures, wherein only small phase imbalances (usually less than 10°) and almost no amplitude imbalances have to be corrected.

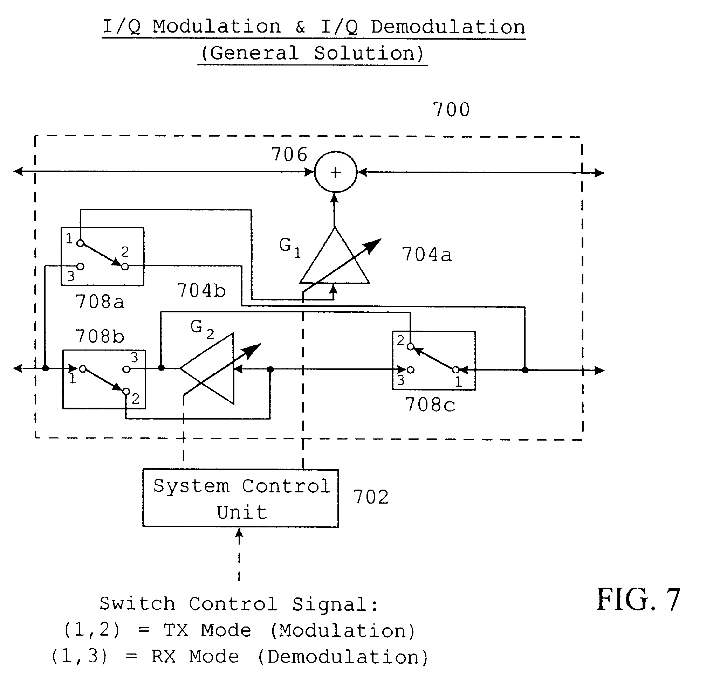

In Fig. 7 an overview block diagram exhibiting a general first solution 700 for the analog four-port hardware structure 404a comprising analog means for providing an I/Q imbalance compensation in case of I/Q demodulation and/or I/Q modulation for time division half duplex radio systems is presented. The main difference compared to the general first solution 500a and 600a as depicted in Figs. 5a and 6a is that there is a switch functionality similarly acting as TX/RX switches 708a-c. For example, in order to enable the receive (RX) mode, all TX/RX switches 708a-c are placed in position 1-2. If the transmit (TX) mode shall be enabled, all TX/RX switches 708a-c are placed in position 1-3. It should be noted that the gains $G_1$ and $G_2$ of the employed gain blocks 704a+b, which are controlled by a system control unit 702, may optionally be different during the TX mode (1-3) and the RX mode (1-2).

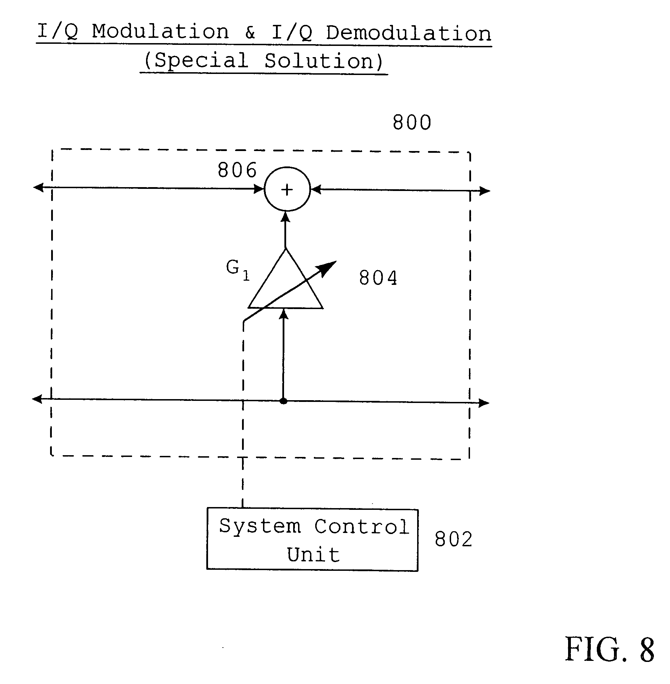

A simplified special version 800 of the proposed analog four-port hardware structure 404a with only one gain block 804 can be taken from Fig. 8. Analogously, the gain $G_1$ of the employed gain block 804 may be different during TX mode and RX mode.

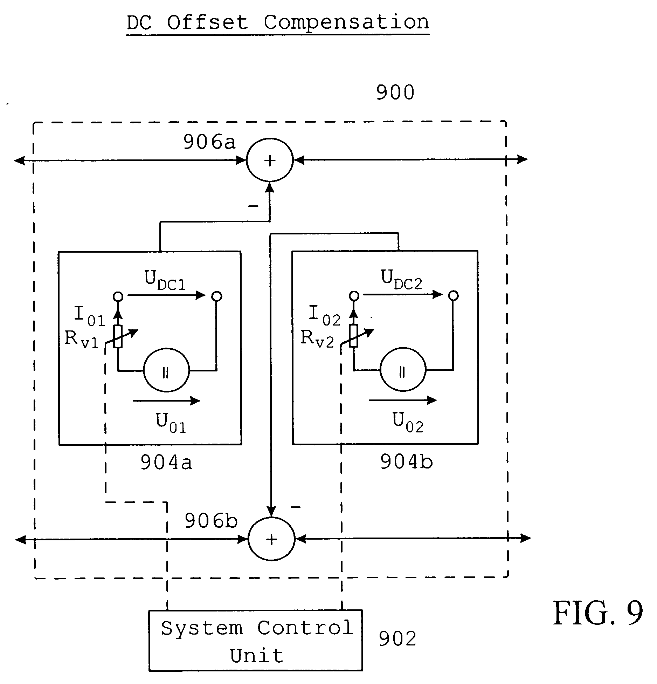

In Fig. 9 a solution 900 for an analog four-port hardware structure 404b is presented which can be used for performing an analog compensation of DC offsets of received RF signals. It consists of two input ports, two output ports and two tunable DC sources which are controlled by means of a system control unit 902. Thereby, a DC offset voltage - $U_{DC1}$ or $U_{DC2}$, respectively - is added to each input signal in order to manage said DC offset compensation. Besides, it should be mentioned that the applied DC voltages $U_{DC1}$ and $U_{DC2}$ may also take negative values.

In this context, the proposed structure can be operated in three modes:

- connected to the I/Q modulator 112a,
- connected to the I/Q demodulator 112b, or
- connected to the joined I/Q modulator and I/Q demodulator structure 410 which can be applied to half duplex time division radio systems.

In the latter case, the values of said DC voltages $U_{DC1}$ and $U_{DC2}$ used for providing a DC offset compensation for either receive (RX) or transmit (TX) operation mode may be different.

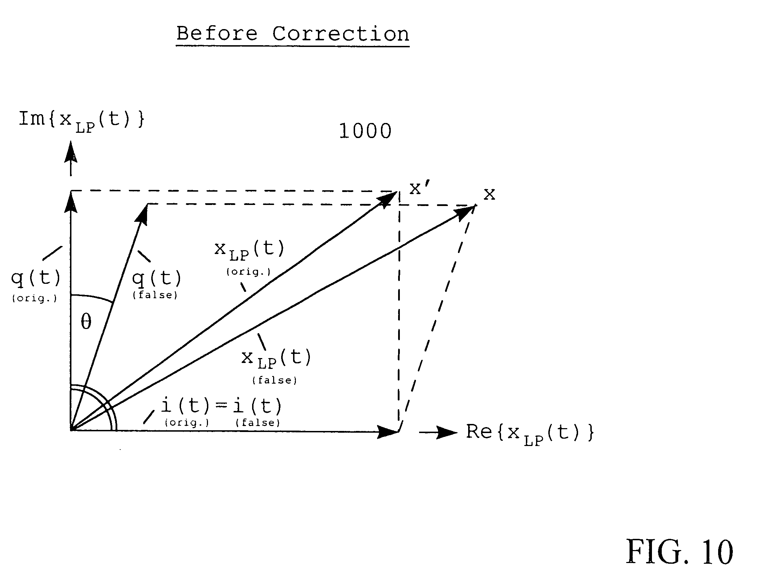

Fig. 10 exhibits a vector diagram 1000 which illustrates the problem of an I/Q imbalance before an imbalance compensation is performed. If the in-phase signal i(t) and the quadrature q(t) signal are plotted in a complex diagram, adding i(t) and j·q(t) leads to a false end position $x_{LP}(t)$, marked with "x". The precise position $x_{LP}'(t)$, marked with "x'", can not be achieved due to a phase mismatch between the in-phase (I) signal and the quadrature (Q) signal. In other words, the phase difference between the in-phase signal (I) and the quadrature (Q) signal is not equal to 90°.

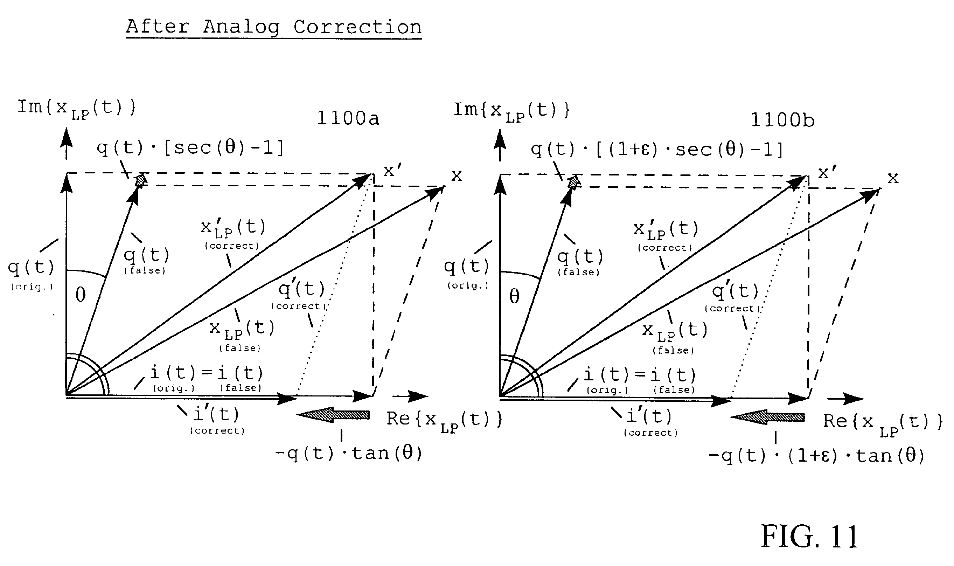

In Fig. 11 two mechanisms 1100a+b according to the preferred embodiment of the underlying invention for compensating the I/Q imbalance are presented, which are realized by means of the analog four-port hardware structure as depicted in Figs. 2 to 8. Using equation (1), the correction procedure in case of a phase mismatch θ without any amplitude mismatch ε can be described as follows:

$$\begin{bmatrix} i'(t) \\ q'(t) \end{bmatrix} = \begin{pmatrix} 1 & G_1 \\ 0 & G_2 \end{pmatrix} \cdot \begin{bmatrix} i(t) \\ q(t) \end{bmatrix}$$

wherein

$$G_1 := -\tan(\theta) \approx -\theta \cdot \frac{\pi}{180°} \text{ for } \theta \cdot \frac{\pi}{180°} \ll 1,$$

and

$$G_2 := \sec(\theta) \equiv \frac{1}{\cos(\theta)} \approx 1 \qquad \text{for } \theta \cdot \frac{\pi}{180°} \ll 1.$$

If both an amplitude mismatch $\varepsilon$ and a small phase mismatch $\theta$ have to be considered, the correction yields:

$$\begin{bmatrix} i'(t) \\ q'(t) \end{bmatrix} = \begin{pmatrix} 1 & G_1 \\ 0 & G_2 \end{pmatrix} \cdot \begin{bmatrix} i(t) \\ q(t) \end{bmatrix}$$

wherein

$$G_1 := -K \cdot \tan(\theta) \approx -K \cdot \theta \cdot \frac{\pi}{180°} \text{ for } \theta \cdot \frac{\pi}{180°} \ll 1,$$

and

$$G_2 := K \cdot \sec(\theta) \equiv \frac{K}{\cos(\theta)} \approx K \text{ for } \theta \cdot \frac{\pi}{180°} \ll 1,$$

thereby using $K := 1 + \varepsilon$.

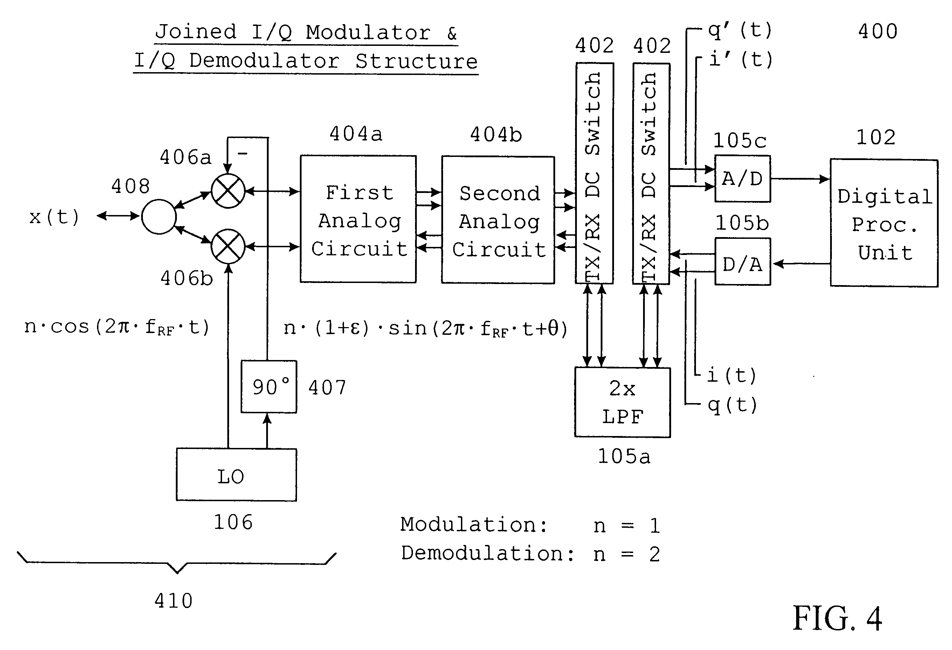

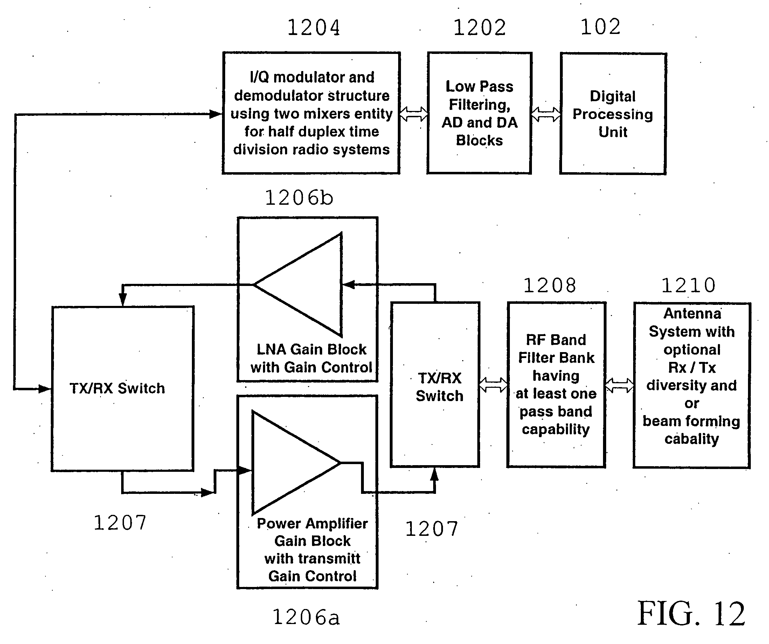

Fig. 12 shows the entire direct down- and up-conversion RF system 1200 according to the preferred embodiment of the underlying invention comprising a joined I/Q modulator and I/Q demodulator structure 1204 as depicted in Fig. 4. Said system can advantageously be applied to the HiperLAN/2 (H2) standard and the IEEE 802.11a RF architecture solution being operated between 5 and 6 GHz. Furthermore, the proposed system 1200 can advantageously be realized by integrating components providing different RF functions on the same RF chip. For the integration of major functional blocks - aside from functional blocks comprising a power amplifier gain block 1206a and a low noise amplifier gain block 1206b - CMOS technology is applied. It should be noted that the antenna system 1210 shown in Fig. 12 can optionally comprise antenna diversity technology such as switching, combining and/or beamforming with more than one antenna element.

In the following, the calibration procedure performed in the demodulator shall be explained in detail.

1. Phase offset compensation

In order to describe the calibration procedure applied to compensate phase offsets, an input signal shall be assumed at the input ports of the I/Q demodulator showing a specific frequency offset $f_{IF}$ compared with the frequency $f_{LO}$ of the local oscillator (LO). After having sampled the input signals i(t) and q(t), the real phase difference $\Delta\Phi$ between these signals can be measured by calculating

$$\Delta\Phi \; := \; \angle\left[I\left(f_k = \left|f_{in} - f_{LO}\right|\right) \cdot Q^*\left(f_k = \left|f_{in} - f_{LO}\right|\right)\right]$$

$$= \begin{cases} \angle I\left(f_k = \left|f_{in} - f_{LO}\right|\right) - \angle Q\left(f_k = \left|f_{in} - f_{LO}\right|\right) & \text{for} & k_1 \cdot k_2 > -1 \\ -180° + \angle I\left(f_k = \left|f_{in} - f_{LO}\right|\right) - \angle Q\left(f_k = \left|f_{in} - f_{LO}\right|\right) & \text{for } k_1 > 0 \wedge k_1 \cdot k_2 < -1 \\ +180° + \angle I\left(f_k = \left|f_{in} - f_{LO}\right|\right) - \angle Q\left(f_k = \left|f_{in} - f_{LO}\right|\right) & \text{for } k_1 < 0 \wedge k_1 \cdot k_2 < -1 \end{cases}$$

with

$$k_1 := \frac{\text{Im}\left\{I\left(f_k = \left|f_{in} - f_{LO}\right|\right)\right\}}{\text{Re}\left\{I\left(f_k = \left|f_{in} - f_{LO}\right|\right)\right\}} \quad \text{and} \quad k_2 := \frac{\text{Im}\left\{Q\left(f_k = \left|f_{in} - f_{LO}\right|\right)\right\}}{\text{Re}\left\{Q\left(f_k = \left|f_{in} - f_{LO}\right|\right)\right\}},$$

thereby using

$$\angle z = \begin{cases} \text{arc tan}\left(\text{Im}\{z\}/\text{Re}\{z\}\right) & \text{for } \text{Re}\{z\} > 0 \text{ and } \text{Im}\{z\} > 0 \\ 360° + \text{arc tan}\left(\text{Im}\{z\}/\text{Re}\{z\}\right) & \text{for } \text{Re}\{z\} > 0 \text{ and } \text{Im}\{z\} < 0 \\ 180° + \text{arc tan}\left(\text{Im}\{z\}/\text{Re}\{z\}\right) & \text{for } \text{Re}\{z\} < 0 \\ 0° & \text{for } \text{Re}\{z\} > 0 \text{ and } \text{Im}\{z\} = 0 \\ 90° & \text{for } \text{Re}\{z\} = 0 \text{ and } \text{Im}\{z\} > 0 \\ 180° & \text{for } \text{Re}\{z\} < 0 \text{ and } \text{Im}\{z\} = 0 \\ 270° & \text{for } \text{Re}\{z\} = 0 \text{ and } \text{Im}\{z\} < 0 \end{cases}$$

$\forall\, z \equiv \text{Re}\{z\} + j\cdot\text{Im}\{z\} = |z|\cdot e^{j\cdot\angle z} \in C$ with $\angle z \in [0°;360°[$ (on the assumption that $|z| \neq 0$)

and

$$\text{arc tan}\left(\frac{x - y}{1 + x \cdot y}\right)$$

$$= \begin{cases} \text{arc tan } x - \text{arc tan } y & \text{for} & x \cdot y > -1 \\ -180° + \text{arc tan } x - \text{arc tan } y & \text{for } x > 0 \wedge x \cdot y < -1 \\ +180° + \text{arc tan } x - \text{arc tan } y & \text{for } x < 0 \wedge x \cdot y < -1 \end{cases}$$

$$\text{with } x, y \in \wp,$$

wherein

$f_{in} \equiv f_{RF}$     is the frequency of the received RF signal before being down-converted to an intermediate frequency (IF),

$f_{LO}$     is the frequency of the local oscillator (LO) applied to the I/Q demodulator,

$f_{IF} = |f_{in} - f_{LO}|$     is an intermediate frequency (IF),

$I(f_k) = FFT\{i(t_n)\}$     denotes the Fast Fourier Transform of the sampled in-phase (I) signal calculated at

$= \sum_{n=0}^{N-1} i(t_n) \cdot e^{-j \cdot 2\pi \cdot k \cdot n / N}$     the discrete frequency $f_k$ ($k = 0, \ldots, N-1$),

$Q(f_k) = FFT\{q(t_n)\}$     denotes the Fast Fourier Transform of the sampled quadrature (Q) signal calculated

$= \sum_{n=0}^{N-1} q(t_n) \cdot e^{-j \cdot 2\pi \cdot k \cdot n / N}$     at the discrete frequency $f_k$ ($k = 0, \ldots, N-1$),

$e \approx 2.718281828$     represents Euler's constant,

$j := \sqrt{-1}$     represents the imaginary unit, and

$"*"$     denotes the complex conjugate operation.

Said calculation yields a phase difference $\Delta\Phi$ which should be close to $\pm90°$. Hence, the obtained phase offset $\theta$ is equal to $90° - \Delta\Phi$.

2. Amplitude offset calibration procedure

In order to describe the calibration procedure applied to compensate amplitude offsets, an input signal shall be assumed at the input ports of the I/Q demodulator showing a frequency offset $f_{IF}$ of a few MHz compared with the frequency $f_{LO}$ of the local oscillator (LO). Ideally, the input signals i(t) and q(t) should be sinusoidal and orthogonal, which means that the phase difference between i(t) and q(t) is exactly equal to $90°$. Then, the real amplitude ratio K between these signals can be measured by calculating

$$K := \left| \frac{I\left(f_k = |f_{in} - f_{LO}|\right)}{Q\left(f_k = |f_{in} - f_{LO}|\right)} \right|.$$

Said calculation yields an amplitude ratio K which should be close to 1. Hence, the obtained amplitude offset $\varepsilon$ is equal to K-1.

In order to perform an amplitude offset calibration procedure for DC offsets arising from an imbalance of the I/Q demodulator, it has to be guaranteed that no signal is present at the input ports of the I/Q demodulator. On the assumption that

$$i(t)=0 \wedge q(t)=0,$$

the average DC levels at the output ports of the in-phase and quadrature signals can be measured. According to another method of the underlying invention, the average of a sinusoidal wave could be measured in order to determine DC offsets.

In order to perform an amplitude offset calibration procedure for DC offsets arising from an imbalance of the I/Q modulator, the RF power at the I output port of the digital-to-analog converter (DAC) has to be measured for the following case:

$$i(t) \sim \sin(2\pi \cdot f_{RF} \cdot t) \wedge q(t) = 0.$$

Next, the RF power at the Q output port of the digital-to-analog converter (DAC) has to be measured for the following case:

$$i(t) = 0 \wedge q(t) \sim \sin(2\pi \cdot f_{RF} \cdot t).$$

After that, the RF power difference between the RF power at the I output port and RF power at the Q output port can be calculated in order to accordingly compensate amplitude offsets. Thereby, it should be mentioned that said calibration may be performed in the process of manufacturing.

During the process of calibration the gain values $G_1$, $G_2$ needed for a compensation of the I/Q imbalance and the DC offset voltages $U_{DC1}$ and $U_{DC2}$ needed for a correction of the DC offsets are calculated and after that fed to the digital processing unit 102. It determines the values of $G_1$, $G_2$, $U_{DC1}$ and $U_{DC2}$ for a specific frequency channel of operation. It should be noted that the calibration may be performed in the process of manufacturing. Thereby, said digital processing unit 102 is provided with a look-up table comprising predefined compensation settings.

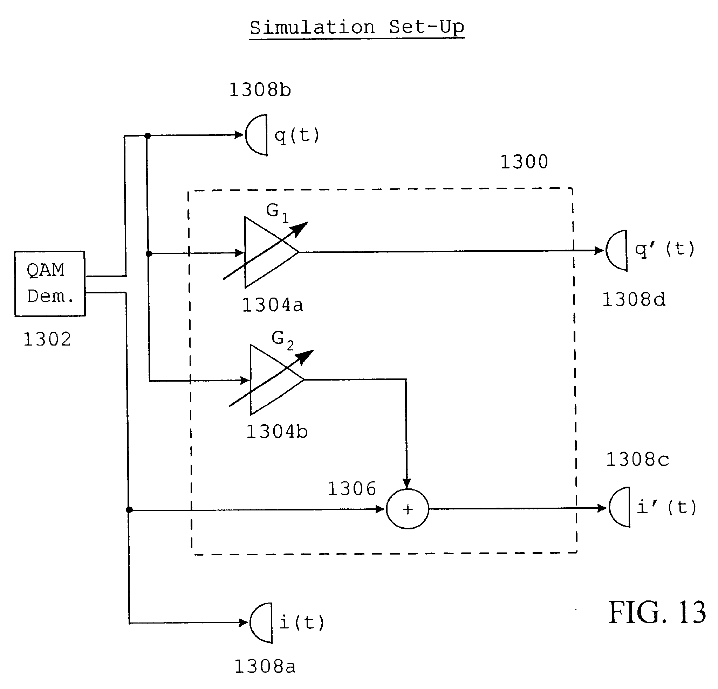

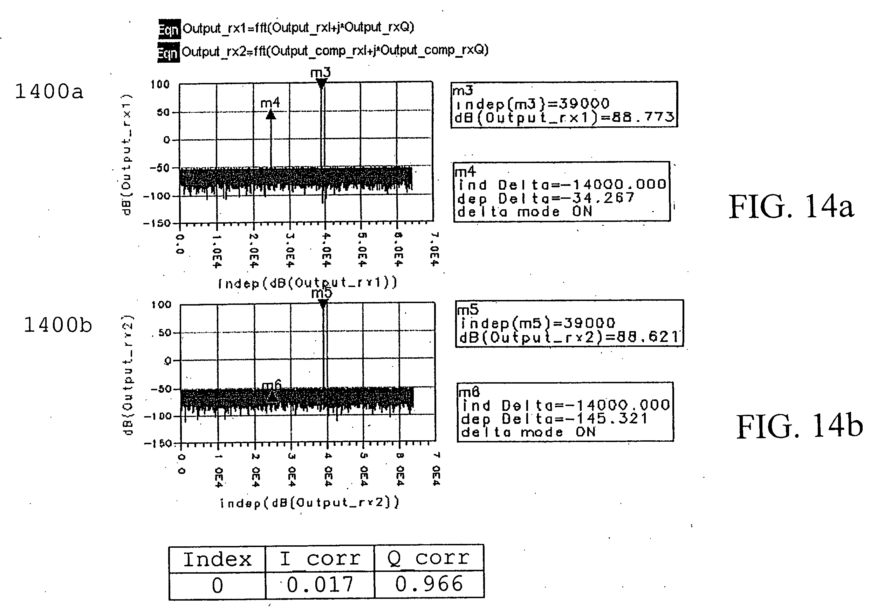

A simulation of the I/Q compensation is depicted in Figs. 13 and 14. The simulation set-up 1300 is shown in Fig. 13, which exhibits the compensation of the in-phase (I) and the quadrature (Q) channels according to the preferred embodiment of the underlying invention. Here, a precise 90° phase and 0 dB amplitude relationship can be achieved between the in-phase (I) and the quadrature (Q) channel.

Fig. 14a exhibits a FFT spectrum 1400a in case of a single-sideband (SSB) rejection, in which a compensation of the I/Q imbalance is not performed. Analogously, Fig. 14b exhibits a FFT spectrum 1400b in case of a single-sideband (SSB) rejection, in which a compensation of the I/Q imbalance is performed according to the preferred embodiment of the underlying invention. Thereby, the scalar gains $G_1$ and $G_2$ of the compensation amplifiers can be taken from the square box at the very bottom. As can be seen from Figs. 14a and 14b, the unwanted sideband is much better suppressed at the compensated output under the noise floor.

Measured results for DC offset compensation

In the following sections, the structure of the I/Q modulator as depicted in Fig. 13, which can also be used as an I/Q demodulator, is analyzed. It comprises two mixers 1304a+b, and one 90° coupler providing them with a LO frequency. The offset voltages applied to compensate DC offsets at the output ports 1308a+b of the in-phase (I) and quadrature (Q) signal can be taken from the following table:

| LO Frequency [GHz] | DC Offset Voltage $U_{DC1}$ [mV] at the Output Port of the In-phase (I) Signal | DC Offset Voltage $U_{DC2}$ [mV] at the Output Port of the Quadrature (Q) Signal |
|---|---|---|
| 5.0 | +57 | -43 |
| 5.1 | +52 | -54 |
| 5.2 | +44 | -61 |
| 5.3 | +31 | -69 |
| 5.4 | +18 | -79 |
| 5.5 | +7 | -84 |
| 5.6 | -10 | -88 |
| 5.7 | -26 | -86 |
| 5.8 | -46 | -85 |
| 5.9 | -65 | -75 |

(continued)

| LO Frequency [GHz] | DC Offset Voltage $U_{DC1}$ [mV] at the Output Port of the In-phase (I) Signal | DC Offset Voltage $U_{DC2}$ [mV] at the Output Port of the Quadrature (Q) Signal |
|---|---|---|
| 6.0 | -87 | -68 |

Thereby, the LO frequency $f_{LO}$ is varied between 5 and 6 GHz, and a sinusoidal input signal is placed at a frequency offset $f_{IF}$ of 9 MHz away from the carrier frequency $f_{RF}$. By adding said offset values as depicted in Fig. 9, a carrier cancellation of 40 dB can be achieved. It should be noted that the applied offset values $U_{DC1}$ and $U_{DC2}$ are steadily changing, if different frequencies or different communication channels within the 5 to 6 GHz band are used.

In other words, specific settings of $U_{DC1}$ and $U_{DC2}$ can advantageously be applied to specific communications channels. Thereby, the system control unit 502, 602, 702 or 802 sets said DC calibration values $U_{DC1}$ and $U_{DC2}$ by simultaneously addressing the specific operation channel and selecting specific LO frequencies. Alternatively, if the number of operation frequency channels is limited, said DC calibration values $U_{DC1}$ and $U_{DC2}$ are calculated by means of a polynomial interpolation of the given calibration. By changing the values of the voltages $U_{DC1}$ and $U_{DC2}$ in the range of -100 to +100 mV, a DC offset compensation can be achieved.

The significance of the symbols designated with reference signs in the Figs. 1a to 14b can be taken from the appended table of reference signs.

Table of the depicted features and their corresponding reference signs

| No. | Feature |
|---|---|
| 100a | block diagram showing the structure of the I/Q modulator 112a in a mobile transmitter according to the state of the art |
| 100b | block diagram showing the structure of the I/Q demodulator 112b in a direct down-conversion receiver according to the state of the art |
| 102 | digital processing unit used for a digital compensation of the I/Q imbalance |
| 104a | combined structure comprising two low-pass filters 105a and two digital-to-analog converters 105b |
| 104b | combined structure comprising two low-pass filters 105a and two analog-to-digital converters 105c |
| 105a | low-pass filter (LPF) |
| 105b | digital-to-analog converter (DAC) |
| 105c | analog-to-digital converter (ADC) |
| 106 | local oscillator (LO) |
| 108a | 1st up-conversion mixer of the I/Q modulator 112a |
| 108b | 2nd up-conversion mixer of the I/Q modulator 112a |
| 108c | 1st down-conversion mixer of the I/Q demodulator 112b |
| 108d | 2nd down-conversion mixer of the I/Q demodulator 112b |
| 109a | 90° phase shifter (Hilbert transformer) of the I/Q modulator 112a |
| 109b | 90° phase shifter (Hilbert transformer) of the I/Q demodulator 112b |
| 110a | summation element of the I/Q modulator 112a |
| 110b | splitting element of the I/Q demodulator 112b |
| 112a | I/Q modulator of a mobile transmitter according to the state of the art |
| 112b | I/Q demodulator of a direct down-conversion receiver |
| 200 | structure of the I/Q demodulator 112b comprising additional analog hardware functionality 202a+b |
| 202a | 1st analog four-port hardware structure for performing an I/Q imbalance compensation in the scope of an I/Q demodulation |
| 202b | 2nd analog four-port hardware structure for performing a DC offset compensation in the scope of an I/Q demodulation |

(continued)

| No. | Feature |
|---|---|
| 300 | structure of the I/Q modulator 112a comprising additional analog hardware functionality |
| 302a | 1st analog four-port hardware structure for performing an I/Q imbalance compensation in the scope of an I/Q modulation |
| 302b | 2nd analog four-port hardware structure for performing a DC offset compensation in the scope of an I/Q modulation |
| 400 | functionality of the proposed joined I/Q modulator and I/Q demodulator 410, which is suitable for half duplex time division radio systems |
| 402 | TX/RX direct current (DC) switch |
| 404a | 1st analog four-port hardware structure for performing an I/Q imbalance compensation applied to calibrate a joined I/Q modulator and I/Q demodulator 410 applied to half duplex time division radio systems |
| 404b | 2nd analog four-port hardware structure for performing a DC offset compensation applied to calibrate a joined I/Q modulator and I/Q demodulator 410 applied to half duplex time division radio systems |
| 406a | 1st up-/down-conversion mixer of the joined I/Q modulator and I/Q demodulator 410 |
| 406b | 2nd up-/down-conversion mixer of the joined I/Q modulator and I/Q demodulator 410 |
| 407 | 90° phase shifter (Hilbert transformer) of the joined I/Q modulator and I/Q demodulator 410 |
| 408 | summation/splitting element of the joined I/Q modulator and I/Q demodulator 410 |
| 410 | joined I/Q modulator and I/Q demodulator structure applied to half duplex time division radio systems |
| 500a | general solution for the proposed analog four-port hardware structure 404a used for compensating the I/Q imbalance of an I/Q modulator 112a |
| 500b | special solution for the proposed analog four-port hardware structure 404a with a reduced complexity used for compensating the I/Q imbalance of an I/Q modulator 112a, which can be used when the phase imbalance is considered as small |
| 502 | system control unit applied to adjust the gain values of the variable gain amplifiers 504a (and 504b) of the analog four-port hardware structure 404a |
| 504a | 1st variable gain amplifier (VGA) providing the gain value $G_1$ according to the general and/or special solution 500a/b for the proposed analog four-port hardware structure 404a |
| 504b | 2nd variable gain amplifier (VGA) providing the gain value $G_2$ according to the general solution 500a for the proposed analog four-port hardware structure 404a |
| 506 | summation element according to the general and/or special solution 500a/b for the proposed analog four-port hardware structure 404a |
| 600a | general solution for the proposed analog four-port hardware structure 404a used for compensating the I/Q imbalance of an I/Q demodulator 112b |
| 600b | special solution for the proposed analog four-port hardware structure 404a with a reduced complexity used for compensating the I/Q imbalance of an I/Q demodulator 112b, which can be used when the phase imbalance is considered as small |
| 602 | system control unit applied to adjust the gain values of the variable gain amplifiers 604a (and 604b) of the analog four-port hardware structure 404a |
| 604a | 1st variable gain amplifier (VGA) providing the gain value $G_1$ according to the general and/or special solution 600a/b for the proposed analog four-port hardware structure 404a |
| 604b | 2nd variable gain amplifier (VGA) providing the gain value $G_2$ according to the general solution 600a for the proposed analog four-port hardware structure 404a |
| 606 | summation element according to the general and/or special solution 600a/b for the proposed analog four-port hardware structure 404a |

(continued)

| No. | Feature |
|---|---|
| 700 | general solution for the proposed analog four-port hardware structure 404a used for compensating the I/Q imbalance in case of a joined I/Q demodulator and I/Q modulator 410 applied to half duplex time division radio systems |
| 702 | system control unit applied to adjust the gain values of the variable gain amplifiers 704a (and 704b) of the analog four-port hardware structure 404a |
| 704a | 1st variable gain amplifier (VGA) providing the gain value $G_1$ according to the general solution 700 for the proposed analog four-port hardware structure 404a |
| 704b | 2nd variable gain amplifier (VGA) providing the gain value $G_2$ according to the general solution 700 for the proposed analog four-port hardware structure 404a |
| 706 | summation element according to the general solution 700 for the proposed analog four-port hardware structure 404a |
| 708a | 1st TX/RX switch according to the general solution 700 for the proposed analog four-port hardware structure 404a |
| 708b | 2nd TX/RX switch according to the general solution 700 for the proposed analog four-port hardware structure 404a |
| 708c | 3rd TX/RX switch according to the general solution 700 for the proposed analog four-port hardware structure 404a |
| 800 | special solution for the proposed analog four-port hard-<br>ware structure 404a with reduced complexity used for compensating the I/Q imbalance for the joined case of an I/Q demodulator and an I/Q modulator 410 applied to half duplex time division radio systems for cases where the phase imbalance can be considered as small |
| 802 | system control unit applied to adjust the gain value of the variable gain amplifier 804 of the analog four-port hardware structure 404a |
| 804 | variable gain amplifier (VGA) providing the gain value $G_1$ according to the special solution 800 for the proposed analog four-port hardware structure 404a |
| 806 | summation element according to the general solution 800 for the proposed analog four-port hardware structure 404a |
| 900 | solution for the proposed analog four-port hardware structure 404b used for compensating DC offsets |
| 902 | system control unit applied to adjust the DC offset voltages of the adjustable constant-voltage generators 904a+b of the analog four-port hardware structure 404b |
| 904a | 1st adjustable constant-voltage generator providing the DC offset voltage $U_{DC1}$ according to the solution 900 for the proposed analog four-port hardware structure 404b |
| 904b | 2nd adjustable constant-voltage generator providing the DC offset voltage $U_{DC2}$ according to the solution 900 for the proposed analog four-port hardware structure 404b |
| 906a | 1st summation element according to the solution 900 for the proposed analog four-port hardware structure 404b |
| 906b | 2nd summation element according to the solution 900 for the proposed analog four-port hardware structure 404b |
| 1000 | vector diagram showing the problem of the I/Q imbalance before being compensated |
| 1100a | 1st mechanism for compensating the I/Q imbalance realized by means of the analog four-port hardware structure 404a as depicted in Figs. 4 to 8 in case of phase mismatches (relative to the in-phase input signal) without any amplitude mismatches |
| 1100b | 2nd mechanism for compensating the I/Q imbalance realized by means of the analog four-port hardware structure 404a as depicted in Figs. 4 to 8 in case of phase mismatches (relative to the in-phase input signal) and amplitude mismatches |

(continued)

| No. | Feature |
| --- | --- |
| 1200 | complete direct down-conversion receiver realizing the analog approach |
| 1202 | combined structure comprising low-pass filters (LPFs), analog-to-digital converters (ADCs) and digital-to-analog converters (DACs) |
| 1204 | combined structure comprising an I/Q modulator and an I/Q demodulator using two up-/down-conversion mixers applied to half duplex time division radio systems |
| 1206a | power amplifier (PA) gain block comprising means for performing an automatic gain control (AGC) |
| 1206b | low noise amplifier (LNA) gain block comprising means for performing an automatic gain control (AGC) |
| 1207 | TX/RX switch |
| 1208 | RF band filter bank comprising at least one band pass filter (BPF) |
| 1210 | antenna system with an optional RX/TX diversity or beam-forming capability |
| 1300 | simulation set-up for the compensation of the in-phase (I) and quadrature (Q) channel |
| 1302 | I/Q demodulator |
| 1304a | $1^{st}$ variable gain amplifier (VGA) having the gain value $G_1$ |
| 1304b | $2^{nd}$ variable gain amplifier (VGA) having the gain value $G_2$ |
| 1306 | summation element |
| 1308a | $1^{st}$ input port providing the uncompensated in-phase channel input signal i(t) |
| 1308b | $2^{nd}$ input port providing the uncompensated quadrature channel input signal q(t) |
| 1308c | $1^{st}$ output port providing the compensated in-phase channel output signal i'(t) |
| 1308d | $2^{nd}$ output port providing the compensated quadrature channel output signal q'(t) |
| 1400a | FFT spectrum in case of a single-sideband (SSB) rejection, in which a compensation of the I/Q imbalance is not performed |
| 1400b | FFT spectrum in case of a single-sideband (SSB) rejection, in which a compensation of the I/Q imbalance is performed |

**Claims**

1. An analog four-port hardware structure for processing modulated RF signals, wherein said analog four-port hardware structure (404a) comprises:

   - a first input port ($IP_1$) for a first analog input signal,
   - a second input port ($IP_2$) for a second analog input signal,
   - a first output port ($OP_1$) for a first analog output signal,
   - a second output port ($OP_2$) for a second analog output signal,
   - at least two variable gain amplifiers (604a+b) providing different gain values ($G_1$ and $G_2$) for amplifying analog signals,
   - at least one summation element (606) for adding analog signals,

   wherein

   - a signal from the second input port ($IP_2$) is multiplied by a positive or negative real factor ($G_1$), added to the first analog input signal and fed to the first output port ($OP_1$), and
   - a signal from the second input port ($IP_2$) is multiplied by a positive or negative real factor ($G_2$) and fed to the second output port ($OP_2$),

**characterized in that**
said analog four-port hardware structure (404a) is connected between the down-conversion mixers (108c+d) and the analog-to-digital converter (105c) in a demodulator structure (200) in order to compensate imbalances caused by amplitude and/or phase offsets of said demodulator (112b).

2. An analog four-port hardware structure for processing modulated RF signals, wherein said analog four-port hardware structure (404a) comprises:

- a first input port ($IP_1$) for a first analog input signal,
- a second input port ($IP_2$) for a second analog input signal,
- a first output port ($OP_1$) for a first analog output signal,
- a second output port ($OP_2$) for a second analog output signal,
- a variable gain amplifier (604a) providing a gain value ($G_1$) for amplifying an analog signal,
- one summation element for adding analog signals,

wherein

- a signal from the second input port ($IP_2$) is multiplied by a positive or negative real factor ($G_1$), added to the first input signal and fed to the first output port ($OP_1$), and
- a signal from the second input port ($IP_2$) is fed to the second output port ($OP_2$),

**characterized in that**
said analog four-port hardware structure (404a) is connected between the down-conversion mixers (108c+d) and the analog-to-digital converter (105c) in a demodulator structure (200) in order to compensate imbalances caused by amplitude and/or phase offsets of said demodulator (112b).

3. An analog four-port hardware structure according to anyone of the claims 1 and 2,
**characterized in that**
said analog four-port hardware structure (404a) is attached to an I/Q demodulator (112b).

4. An analog four-port hardware structure according to claim 3,
**characterized in that**
the first analog input signal is the in-phase (I) signal and the second analog input signal is the quadrature (Q) signal of said I/Q demodulator (112b).

5. An analog four-port hardware structure according to claim 3,
**characterized in that**
the first analog input signal is the quadrature (Q) signal and the second analog input signal is the in-phase (I) signal of said I/Q demodulator (112b).

6. An analog four-port hardware structure according to anyone of the claims 1 to 5,
comprising an additional analog four-port hardware structure (404b), which is placed immediately before or after said analog four-port hardware structure (404a), comprising:

- a first input port ($IP_1'$) for a first analog input signal,
- a second input port ($IP_2'$) for a second analog input signal,
- a first output port ($OP_1'$) for a first analog output signal,
- a second output port ($OP_2'$) for a second analog output signal,

**characterized in that**
different DC voltages ($U_{DC1}$, $U_{DC2}$) being optionally controlled by a system control unit (602) are added to each of said analog input signals.

7. An analog four-port hardware structure used for processing modulated RF signals, wherein said analog four-port hardware structure (404a) comprises:

- a first input port ($IP_1$) for a first analog input signal,
- a second input port ($IP_2$) for a second analog input signal,

- a first output port ($OP_1$) for a first analog output signal,
- a second output port ($OP_2$) for a second analog output signal,
- at least two variable gain amplifiers (504a+b) providing different gain values ($G_1$ and $G_2$) for amplifying analog signals,
- at least one summation element (506) for adding analog signals,

wherein

- a signal from the second input port ($IP_2$) is multiplied by a positive or negative real factor ($G_1$), added to the first analog input signal and fed to the first output port ($OP_1$), and
- a signal from the second input port ($IP_2$) is multiplied by a positive or negative real factor ($G_2$) and fed to the second output port ($OP_2$),

**characterized in that**
said analog four-port hardware structure (404a) is connected between the up-conversion mixers (108a+b) and the digital-to-analog converter (105b) in a modulator structure (300) in order to compensate imbalances caused by amplitude and/or phase offsets of said modulator (112a).

8. An analog four-port hardware structure used for processing modulated RF signals, wherein said analog four-port hardware structure (404a) comprises:

- a first input port ($IP_1$) for a first analog input signal,
- a second input port ($IP_2$) for a second analog input signal,
- a first output port ($OP_1$) for a first analog output signal,
- a second output port ($OP_2$) for a second analog output signal,
- a variable gain amplifier (504a) providing a gain value ($G_1$) for amplifying an analog signal,
- one summation element for adding analog signals,

wherein

- a signal from the second input port ($IP_2$) is multiplied by a positive or negative real factor ($G_1$), added to the first input signal and fed to the first output port ($OP_1$), and
- a signal from the second input port ($IP_2$) is fed to the second output port ($OP_2$),

**characterized in that**
said analog four-port hardware structure (404a) is connected between the up-conversion mixers (108a+b) and the digital-to-analog converter (105b) in a modulator structure (300) in order to compensate imbalances caused by amplitude and/or phase offsets of said modulator (112a).

9. An analog four-port hardware structure according to anyone of the claims 7 and 8,
**characterized in that**
said analog four-port hardware structure (404a) is attached to an I/Q modulator (112a) of a mobile transmitter.

10. An analog four-port hardware structure according to claim 9,
**characterized in that**
the first analog input signal is the in-phase (I) signal and the second analog input signal is the quadrature (Q) signal of said I/Q modulator (112a).

11. An analog four-port hardware structure according to claim 9,
**characterized in that**
the first analog input signal is the quadrature (Q) signal and the second analog input signal is the in-phase (I) signal of said I/Q modulator (112a).

12. An analog four-port hardware structure according to anyone of the claims 7 to 11,
comprising an additional analog four-port hardware structure (404b), which is placed immediately before or after said analog four-port hardware structure (404a), comprising:

- a first input port ($IP_1'$) for a first analog input signal,

- a second input port ($IP_2'$) for a second analog input signal,
- a first output port ($OP_1'$) for a first analog output signal,
- a second output port ($OP_2'$) for a second analog output signal,

**characterized in that**
different DC voltages ($U_{DC1}$, $U_{DC2}$) being optionally controlled by a system control unit (502) are added to each of said analog input signals.

13. An analog four-port hardware structure for processing modulated RF signals, wherein said analog four-port hardware structure (404a) comprises:

- a first input port ($IP_1$) for a first analog input signal,
- a second input port ($IP_2$) for a second analog input signal,
- a first output port ($OP_1$) for a first analog output signal,
- a second output port ($OP_2$) for a second analog output signal,
- at least two variable gain amplifiers (704a+b) providing different gain values ($G_1$ and $G_2$) for amplifying analog signals,
- at least one summation element (706) for adding analog signals,

wherein

- a signal from the second input port ($IP_2$) is multiplied by a positive or negative real factor ($G_1$), added to the first analog input signal and fed to the first output port ($OP_1$), and
- a signal from the second input port ($IP_2$) is multiplied by a positive or negative real factor ($G_2$) and fed to the second output port ($OP_2$),

**characterized in that**
said analog four-port hardware structure (404a) is connected between the up-/down-conversion mixers (406a+b), the digital-to-analog converter (105b) and/or the analog-to-digital converter (105c) in a joined modulator/demodulator structure (400) in order to compensate imbalances caused by amplitude and/or phase offsets of said joined modulator/demodulator (410).

14. An analog four-port hardware structure used for processing modulated RF signals, wherein said analog four-port hardware structure (404a) comprises:

- a first input port ($IP_1$) for a first analog input signal,
- a second input port ($IP_2$) for a second analog input signal,
- a first output port ($OP_1$) for a first analog output signal,
- a second output port ($OP_2$) for a second analog output signal,
- a variable gain amplifier (704a) providing a gain value ($G_1$) for amplifying an analog signal,
- one summation element for adding analog signals,

wherein

- a signal from the second input port ($IP_2$) is multiplied by a positive or negative real factor ($G_1$), added to the first input signal and fed to the first output port ($OP_1$), and
- a signal from the second input port ($IP_2$) is fed to the second output port ($OP_2$),

**characterized in that**
said analog four-port hardware structure (404a) is connected between the up-/down-conversion mixers (406a+b), the digital-to-analog converter (105b) and/or the analog-to-digital converter (105c) in a joined modulator/demodulator structure (400) of a direct-conversion transceiver in order to compensate imbalances caused by amplitude and/or phase offsets of said joined modulator/demodulator (410).

15. An analog four-port hardware structure according to anyone of the claims 13 and 14,
wherein
said analog four-port hardware structure (404a) is attached to a joined I/Q modulator and I/Q demodulator of a direct-conversion transceiver used for half duplex time division radio systems, comprising:

- at least two up-/down-conversion mixers (406a+b),
- one TX/RX switch (402) at each side of an analog low-pass filter bank comprising at least two analog low-pass filters (105a) with the same cut-off frequency,
- two variable gain amplifiers (704a+b) providing different gain values ($G_1$ and $G_2$) for amplifying analog signals,
- one summation element (706) for adding analog signals,

**characterized in that**
said analog four-port hardware structure (404a) is placed between the up-/down-conversion mixers (406a+b) and one TX/RX switch (402) in order to compensate imbalances caused by amplitude and/or phase offsets.

16. An analog four-port hardware structure according to claim 15,
**characterized in that**
the first analog input signal is the in-phase (I) signal and the second analog input signal is the quadrature (Q) signal of a quadrature demodulator (112b) in a direct down-conversion receiver.

17. An analog four-port hardware structure according to claim 15,
**characterized in that**
the first analog input signal is the quadrature (Q) signal and the second analog input signal is the in-phase (I) signal of a quadrature demodulator (112b) in a direct down-conversion receiver.

18. An analog four-port hardware structure according to anyone of the claims 13 to 17,
comprising an additional analog four-port hardware structure (404b), which is placed immediately before or after said analog four-port hardware structure (404a), comprising:

- a first input port ($IP_1'$) for a first analog input signal,
- a second input port ($IP_2'$) for a second analog input signal,
- a first output port ($OP_1'$) for a first analog output signal,
- a second output port ($OP_2'$) for a second analog output signal,

**characterized in that**
different DC voltages ($U_{DC1}$, $U_{DC2}$) being optionally controlled by a system control unit (902) are added to each of said analog input signals.

19. Method for calibrating the in-phase (I) and the quadrature (Q) signal in the I/Q demodulator (112b) of a direct down-conversion receiver,
**characterized in that**
an analog four-port hardware structure (404a) is applied according to anyone of the claims 1 to 5 to compensate I/Q mismatches caused by amplitude and/or phase imbalances.

20. Method for calibrating the in-phase (I) and the quadrature (Q) signal in the I/Q demodulator (112b) of a direct down-conversion receiver,
**characterized in that**
an analog four-port hardware structure (404b) is applied according to claim 6 to compensate I/Q mismatches caused by DC offset voltages.

21. Method for calibrating the in-phase (I) and the quadrature (Q) signal in the I/Q modulator (112a) of a mobile transmitter,
**characterized in that**
an analog four-port hardware structure (404a) is applied according to anyone of the claims 7 to 11 to compensate I/Q mismatches caused by amplitude and/or phase imbalances.

22. Method for calibrating the in-phase (I) and the quadrature (Q) signal in the I/Q modulator (112a) of a mobile transmitter,
**characterized in that**
an analog four-port hardware structure (404b) is applied according to claim 12 to compensate I/Q mismatches caused by DC offset voltages.

23. Method for calibrating the in-phase (I) and the quadrature (Q) signal in the joined I/Q demodulator and I/Q modulator (410) of a direct-conversion transceiver,
**characterized in that**
an analog four-port hardware structure (404a) is applied according to anyone of the claims 13 to 17 to compensate I/Q mismatches caused by amplitude and/or phase imbalances.

24. Method for calibrating the in-phase (I) and the quadrature (Q) signal in the joined I/Q demodulator and I/Q modulator (410) of a direct-conversion transceiver,
**characterized in that**
an analog four-port hardware structure (404b) is applied according to claim 18 to compensate I/Q mismatches caused by DC offset voltages.

25. A direct down-conversion receiver for receiving modulated radio frequency (RF) signals, comprising:

- at least one antenna for receiving RF signals,
- at least one analog four-port hardware structure (404a+b) according to anyone of the claims 1 to 6,
- one I/Q demodulator (112b) used for a down-conversion of received RF signals to the baseband, comprising:

- one tunable local oscillator (106) for providing at least one reference frequency,
- two down-conversion mixers (108c+d) used for a signal down-conversion of a received signal frequency,

**characterized in that**
at least one of said analog four-port hardware structures (404a+b) is placed between the down-conversion mixers (108c+d) and the analog-to-digital converter (105c) in the demodulator structure (200) of the direct down-conversion receiver in order to compensate imbalances caused by amplitude and/or phase offsets of said I/Q demodulator (112b).

26. A mobile transmitter for transmitting modulated radio frequency (RF) signals, comprising:

- at least one antenna for transmitting RF signals,
- at least one analog four-port hardware structure (404a+b) according to anyone of the claims 7 to 12,
- one I/Q modulator (112a) used for an up-conversion of baseband signals to be transmitted to the radio frequency (RF), comprising:

- one tunable local oscillator (106) for providing at least one reference frequency,
- two up-conversion mixers (108a+b) used for a signal up-conversion of a signal frequency to be transmitted,

**characterized in that**
at least one of said analog four-port hardware structures (404a+b) is placed between the up-conversion mixers (108a+b) and the digital-to-analog converter (105b) in the modulator structure (300) of a mobile transmitter in order to compensate imbalances caused by amplitude and/or phase offsets of said I/Q modulator (112a).

27. A direct-conversion transceiver for transmitting and receiving modulated radio frequency (RF) signals
wherein said direct-conversion transceiver comprises:

- at least one antenna for transmitting and receiving radio frequency (RF) signals, respectively,
- at least one analog four-port hardware structure (404a+b) according to anyone of the claims 13 to 18,
- one joined I/Q demodulator and I/Q modulator (410) used for a down-conversion of received RF signals to the baseband and/or an up-conversion of baseband signals to be transmitted to the radio frequency (RF), comprising:

- at least one tunable local oscillator (106) for providing a reference frequency,
- two up-/down-conversion mixers (406a+b) used for a signal up-/down-conversion of analog signals,

**characterized in that**
at least one of said analog four-port hardware structures (404a+b) is placed between the up-/down-conversion mixers (406a+b), the digital-to-analog converter (105b) and/or the analog-to-digital converter (105c) in the joined I/Q modulator/demodulator structure (400) in order to compensate imbalances caused by amplitude and/or phase offsets of said joined I/Q demodulator and I/Q demodulator (410).

**28.** A method for receiving modulated radio frequency (RF) signals,
**characterized in that**
a direct down-conversion receiver according to claim 25 is employed.

**29.** A method for transmitting modulated radio frequency (RF) signals,
**characterized in that**
a mobile transmitter according to claim 26 is employed.

**30.** A method for transmitting and/or receiving modulated radio frequency (RF) signals,
**characterized in that**
a direct-conversion transceiver according to claim 27 is employed.

**31.** A mobile telecommunications device,
**characterized in that**
it comprises a direct down-conversion receiver according to claim 25.

**32.** A mobile telecommunications device,
**characterized in that**
it comprises a mobile transmitter according to claim 26.

**33.** A mobile telecommunications device,
**characterized in that**
it comprises a direct-conversion transceiver according to claim 27.

I/Q Modulator
Structure

100a

FIG. 1a

EP 1 298 791 A1

EP 1 298 791 A1

I/Q Demodulator
Structure

100b

q(t)

i(t)

104b

108c

110b

102

105a    105c

x(t) →  /

Digital
Processing
Unit

2x
LPF

2x
A/D

108d

$2 \cdot \cos(2\pi \cdot f_{RF} \cdot t)$

$2 \cdot (1+\varepsilon) \cdot \sin(2\pi \cdot f_{RF} \cdot t + \theta)$

90°  109b

Realization of 104b:

LO

105a

$x_{BB}(t)$

q(t)

106

LPF

i(t)

A/D

LPF

105c

105a

112b

FIG. 1b

200

q'(t)

i'(t)

104b

202a    202b    105a    105c    102

$x(t)$ → 110b → 108c (−)

$2 \cdot \cos(2\pi \cdot f_{RF} \cdot t)$

108d

$2 \cdot (1+\varepsilon) \cdot \sin(2\pi \cdot f_{RF} \cdot t + \theta)$

| First Analog Circuit | Second Analog Circuit | 2x LPF | 2x A/D | Digital Processing Unit |

90° 109b

LO

106

112b

Realization of 104b:

105a    $q(t)$    $x_{BB}(t)$

LPF

$i(t)$

LPF    A/D

105a    105c

FIG. 2

EP 1 298 791 A1

I/Q Modulator
Structure

300

$q(t)$

$i(t)$

104a

302a

302b

105a    105b

102

108a

110a

$q'(t)$

First
Analog
Circuit

Second
Analog
Circuit

2x
LPF

2x
D/A

Digital
Processing
Unit

$x(t)$

108b

$i'(t)$

$\cos(2\pi \cdot f_{RF} \cdot t)$

$(1+\varepsilon) \cdot \sin(2\pi \cdot f_{RF} \cdot t + \theta)$

90°  109a

LO

106

112a

FIG. 3

Joined I/Q Modulator &
I/Q Demodulator Structure

$$n \cdot \cos(2\pi \cdot f_{RF} \cdot t) \qquad n \cdot (1+\varepsilon) \cdot \sin(2\pi \cdot f_{RF} \cdot t + \theta)$$

Modulation:    n = 1
Demodulation:  n = 2

FIG. 4

EP 1 298 791 A1

EP 1 298 791 A1

I/Q Modulation
(General Solution)

FIG. 5a

EP 1 298 791 A1

I/Q Modulation
(Special Solution)

500b

506

$i'(t)$ ← ⊕ ← $i(t)$
         +

$G_1$ △ 504a

$q'(t)$ ← $q(t)$

System Control Unit  502

FIG. 5b

I/Q Demodulation
(General Solution)

600a

i(t) ────────────────────────⊕──────────────→ i'(t)
                            606  +

                          G₁  ▶
                             △      604a

                                 604b
                          G₂  ▶
q(t) ──────────────────●────▷──────────→ q'(t)

┌─────────────────────┐
│   System Control    │  602
│        Unit         │
└─────────────────────┘

FIG. 6a

# FIG. 6b

I/Q Demodulation
(Special Solution)

600b

$i(t)$ → $i'(t)$

606 (+)

604a

$G_1$

$q(t)$ → $q'(t)$

System Control Unit

602

## I/Q Modulation & I/Q Demodulation
### (General Solution)

FIG. 7

Switch Control Signal:
(1,2) = TX Mode (Modulation)
(1,3) = RX Mode (Demodulation)

I/Q Modulation & I/Q Demodulation
(Special Solution)

800

804

$G_1$

806

802

System Control Unit

FIG. 8

## DC Offset Compensation

FIG. 9

EP 1 298 791 A1

Before Correction

1000

FIG. 10

# After Analog Correction

FIG. 11

1204     1202     102

**I/Q modulator and demodulator structure using two mixers entity for half duplex time division radio systems**

**Low Pass Filtering, AD and DA Blocks**

**Digital Processing Unit**

1206b

**LNA Gain Block with Gain Control**

1208     1210

**TX/RX Switch**

**TX/RX Switch**

**RF Band Filter Bank having at least one pass band capability**

**Antenna System with optional Rx / Tx diversity and or beam forming cabality**

1207      **Power Amplifier Gain Block with transmitt Gain Control**     1207

1206a

FIG. 12

## Simulation Set-Up

FIG. 13

EP 1 298 791 A1

EP 1 298 791 A1

Eqn Output_rx1=fft(Output_rxI+j*Output_rxQ)

Eqn Output_rx2=fft(Output_comp_rxI+j*Output_comp_rxQ)

1400a

m3
indep(m3)=39000
dB(Output_rx1)=88.773

m4
ind Delta=-14000.000
dep Delta=-34.267
delta mode ON

FIG. 14a

1400b

m5
indep(m5)=39000
dB(Output_rx2)=88.621

m6
ind Delta=-14000.000
dep Delta=-145.321
delta mode ON

FIG. 14b

| Index | I corr | Q corr |
|-------|--------|--------|
| 0 | 0.017 | 0.966 |

# EP 1 298 791 A1

**European Patent Office**

## EUROPEAN SEARCH REPORT

Application Number

EP 01 12 3075

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 546 322 A (NEC CORP.) 16 June 1993 (1993-06-16) * page 5, line 35 - page 7, line 3; figure 3 * | 7-11,26, 29,32 | H03C3/40 |
| Y | | 13-18, 27,30,33 | |
| | * page 5, line 55 - page 6, line 2 * | | |
| Y | * page 7, line 55 - page 8, line 55; figure 7 * | 12 | |
| Y | WO 00 31941 A (TITAN CORP) 2 June 2000 (2000-06-02) * page 1, line 30 - page 2, line 1 * * page 5, line 1 - page 5, line 34; figure 2 * * page 6, line 23 - line 29 * | 12 | |
| X | EP 0 982 849 A (NEC CORP.) 1 March 2000 (2000-03-01) * page 5, line 22 - page 7, line 39; figure 2 * | 7 | |
| A | US 5 559 468 A (P. GAILUS) 24 September 1996 (1996-09-24) * column 2, line 17 - column 3, line 55; figures 1,2 * | 12 | TECHNICAL FIELDS SEARCHED (Int.Cl.7) H03D H03C |
| A | US 4 462 001 A (H. GIRARD) 24 July 1984 (1984-07-24) * column 2, line 57 - column 4, line 37; figure 1 * | 7 | |
| Y | DE 42 38 543 C (HAGENUK GMBH) 5 May 1994 (1994-05-05) * column 5, line 12 - line 42; figure 2 * | 13-18, 27,30,33 | |
| Y | | 19-24 | |
| | -/-- | | |

The present search report has been drawn up for all claims

| Place of search | Date of completion of the search | Examiner |
|---|---|---|
| THE HAGUE | 6 September 2002 | Butler, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

Application Number

EP 01 12 3075

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**EUROPEAN SEARCH REPORT**

Application Number

EP 01 12 3075

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | DE 199 34 215 C (ROHDE & SCHWARTZ GMBH) 29 March 2001 (2001-03-29) * column 2, line 34 - column 3, line 49; figure 1 * | 13-18, 27,30,33 | |
| A | EP 0 180 339 A (STC PLC) 7 May 1986 (1986-05-07) * page 2, line 1 - line 23 * * page 3, line 1 - line 36; figure 1 * * page 4, line 12 - page 6, line 14; claims 1-6; figures 2-6 * | 13-18, 27,30,33 | |
| A | US 6 016 422 A (P. BARTUSIAK) 18 January 2000 (2000-01-18) * column 6, line 1 - column 8, line 51; figure 3 * | 13-18, 27,30,33 | |
| A | J. PAEZBORRALLO: "self adjusting digital image rejection receiver for mobile communications" VEHICULAR TECHNOLOGY CONFERENCE 1997, 4 May 1997 (1997-05-04), pages 686-690, XP000736695 phoenix,Ar,USA * page 687, column 1, line 13 - page 688, column 1, line 9; figures 3-6 * | 13-18, 27,30,33 | TECHNICAL FIELDS SEARCHED (Int.Cl.7) |
| Y | US 6 294 952 B1 (T. KATO) 25 September 2001 (2001-09-25) * column 1, line 33 - line 38 * * column 9, line 1 - column 12, line 51; figures 1-4 * | 19-24 | |
| A | US 5 400 366 A (T. IWAMATSU) 21 March 1995 (1995-03-21) * column 14, line 9 - column 15, line 43; figure 1 * | 19-24 | |

--/--

The present search report has been drawn up for all claims

| Place of search | Date of completion of the search | Examiner |
|---|---|---|
| THE HAGUE | 6 September 2002 | Butler, N |

European Patent
Office

**LACK OF UNITY OF INVENTION**
**SHEET B**

Application Number

EP 01 12 3075

The Search Division considers that the present European patent application does not comply with the requirements of unity of invention and relates to several inventions or groups of inventions, namely:

1. Claims: 1-6,25,28,31

   A receiver using a cascade  comprising a down-conversion
   mixer , a four port orthogonality correction arrangement ,
   two analog to digital converters ,
   and a demodulator circuit .

2. Claims: 7-12,26,29,32

   A transmitter  comprising the technical features :
   a modulator ,
   two digital to analog converters ,
   a four port to correct orthogonality errors ,
   an upconverter .

3. Claims: 13-18,27,30,33

   A transceiver comprising :

   1. a receiver comprising :
   a down conversion mixer ,
   a four port to correct orthogonality errors ,
   analog to digital converters ,
   a demodulator .

   2. a transmitter comprising :
   a modulator ,
   digital to analog converters ,
   a four port to correct orthogonality errors ,
   an up conversion mixer .

4. Claims: 19-24

   A method for calibrating the in-phase and quadrature signals
   in an I/Q demodulator of a direct conversion receiver ,
   using an analog four-port correction circuit .

The subject matters of the four inventions do not contain the same set
of essential technical features when compared with the closest prior art
ep719013 hence there is non-unity of invention .

**European Patent Office**

## EUROPEAN SEARCH REPORT

Application Number

EP 01 12 3075

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 6 118 322 A (D. BOCKELMAN) 12 September 2000 (2000-09-12) * figure 3 * | 19 | |
| A | WO 98 32221 A (ERICSSON) 23 July 1998 (1998-07-23) * page 13, line 1 - page 17, line 21; figures 1-3 * | 19 | |

TECHNICAL FIELDS SEARCHED (Int.Cl.7)

The present search report has been drawn up for all claims

| Place of search | Date of completion of the search | Examiner |
|---|---|---|
| THE HAGUE | 6 September 2002 | Butler, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 01 12 3075

This annex lists the patent family membersrelating to the patent documents cited in the above-mentioned European search report.
The members are as contained in the European Patent Office EDP file on
The European Patent Office is in no way liable for these particulars which are merely given for the purpose of information.

06-09-2002

| Patent document cited in search report | | Publication date | Patent family member(s) | | Publication date |
|---|---|---|---|---|---|
| EP 546322 | A | 16-06-1993 | JP | 5130156 A | 25-05-1993 |
| | | | DE | 69220334 D1 | 17-07-1997 |
| | | | DE | 69220334 T2 | 22-01-1998 |
| | | | EP | 0546322 A1 | 16-06-1993 |
| | | | US | 5355101 A | 11-10-1994 |
| WO 0031941 | A | 02-06-2000 | US | 6298096 B1 | 02-10-2001 |
| | | | EP | 1131929 A1 | 12-09-2001 |
| | | | WO | 0031941 A1 | 02-06-2000 |
| EP 982849 | A | 01-03-2000 | JP | 2000069098 A | 03-03-2000 |
| | | | EP | 0982849 A1 | 01-03-2000 |
| | | | KR | 2000017447 A | 25-03-2000 |
| US 5559468 | A | 24-09-1996 | CN | 1101181 A ,B | 05-04-1995 |
| US 4462001 | A | 24-07-1984 | CA | 1184980 A1 | 02-04-1985 |
| DE 4238543 | C | 05-05-1994 | DE | 4238543 C1 | 05-05-1994 |
| | | | AT | 156635 T | 15-08-1997 |
| | | | DE | 59307069 D1 | 11-09-1997 |
| | | | EP | 0602394 A2 | 22-06-1994 |
| | | | ES | 2106941 T3 | 16-11-1997 |
| DE 19934215 | C | 29-03-2001 | DE | 19934215 C1 | 29-03-2001 |
| EP 180339 | A | 07-05-1986 | GB | 2166324 A | 30-04-1986 |
| | | | AU | 4839385 A | 01-05-1986 |
| | | | EP | 0180339 A2 | 07-05-1986 |
| | | | JP | 61105948 A | 24-05-1986 |
| | | | US | 4731796 A | 15-03-1988 |
| US 6016422 | A | 18-01-2000 | NONE | | |
| US 6294952 | B1 | 25-09-2001 | JP | 2001333120 A | 30-11-2001 |
| | | | CN | 1275012 A | 29-11-2000 |
| | | | DE | 10023734 A1 | 28-12-2000 |
| | | | GB | 2350504 A | 29-11-2000 |
| US 5400366 | A | 21-03-1995 | JP | 3300040 B2 | 08-07-2002 |
| | | | JP | 6030073 A | 04-02-1994 |
| | | | JP | 6054014 A | 25-02-1994 |
| | | | US | 5661761 A | 26-08-1997 |
| | | | US | 5594759 A | 14-01-1997 |
| US 6118322 | A | 12-09-2000 | NONE | | |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 01 12 3075

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2002

| Patent document cited in search report | Publication date | Patent family member(s) | Publication date |
|---|---|---|---|
| WO 9832221 A | 23-07-1998 | US 6009317 A<br>AU 5732398 A<br>WO 9832221 A1 | 28-12-1999<br>07-08-1998<br>23-07-1998 |

EPO FORM P0459

For more details about this annex : see Official Journal of the European Patent Office, No. 12/82